# EUROPEAN PATENT APPLICATION

(11) **EP 4 756 809 A1**
(43) Date of publication of application: **10.06.2026**
(21) Application number: 25218052.6
(22) Date of filing: 24.11.2025
(51) Int. Cl.: G11C 16/08, G11C 16/10, G11C 16/24, G11C 16/04

(54) **MEMORY DEVICE INCLUDING A PLURALITY OF CELL LAYERS**

(30) Priority: 03.12.2024 KR 20240177149
(71) Applicant: Samsung Electronics Co., Ltd., Suwon-si, Gyeonggi-do 16677 (KR)
(72) Inventor: JOE, Sung-Min, 16677 Suwon-si (KR); MOON, Seunghyun, 16677 Suwon-si (KR); CHAE, Donghyuk, 16677 Suwon-si (KR)
(74) Representative: Marks & Clerk LLP

(57) **Abstract**

A memory device (100) includes a first cell layer (CL1), a second cell layer (CL2) stacked on the first cell layer (CL1), a third cell layer (CL3) stacked on the second cell layer (CL2), a fourth cell layer (CL4) stacked on the third cell layer (CL3), a first page buffer (PB1) connected to a first string (ST1) included in the first cell layer (CL1) and a third string (ST3) included in the third cell layer (CL3), a second page buffer (PB2) connected to a second string (ST2) included in the second cell layer (CL2) and a fourth string (ST4) included in the fourth cell layer (CL4), and a control logic circuit (170) configured to control the first page buffer (PB1) and the second page buffer (PB2) to perform a respective core operation on each of the first cell layer (CL1) and the second cell layer (CL2).

## Description

### BACKGROUND

The present disclosure relates to a memory device including a plurality of cell arrays.

Memory devices are used to store data and include volatile memory devices and non-volatile memory devices. A flash memory device, an example of a non-volatile memory device, may be used in mobile phones, digital cameras, portable computer devices, stationary computer devices, or other devices.

With the recent trend toward multifunctional information and communication devices, there is growing demand for memory devices with larger capacities and higher integration densities. Accordingly, a three-dimensional (3D) non-volatile memory device including a plurality of wordlines stacked vertically on a substrate has been proposed. In addition, research into bonding techniques to connect cell layers formed on different wafers is in progress.

### SUMMARY

One or more implementations provide a memory device that controls two adjacent cell layers, among a plurality of stacked cell layers, through different page buffers.

According to one or more implementations, a memory device includes a first cell layer, a second cell layer stacked on the first cell layer, a third cell layer stacked on the second cell layer, a fourth cell layer stacked on the third cell layer, a first page buffer connected to a first string of the first cell layer and a third string of the third cell layer, a second page buffer connected to a second string of the second cell layer and a fourth string of the fourth cell layer, and a control logic circuit configured to control the first page buffer and the second page buffer to perform a respective core operation on each of the first cell layer and the second cell layer.

According to one or more implementations, a memory device includes a first cell layer including a first string, a second cell layer stacked on the first cell layer and including a second string, a first page buffer connected to the first string, a second page buffer connected to the second string, and a control logic circuit configured to control the first page buffer and the second page buffer to perform a respective core operation on each of the first cell layer and the second cell layer.

According to one or more implementations, a memory device includes a first cell layer including a first string, a second cell layer stacked on the first cell layer and including a second string, a third cell layer stacked on the second cell layer and including a third string, a fourth cell layer stacked on the third cell layer and including a fourth string, and a peripheral circuit connected to the first cell layer, the second cell layer, the third cell layer, and the fourth cell layer. The peripheral circuit may include a first page buffer connected to the first string and the third string and a second page buffer connected to the second string and the fourth string.

At least some of the above and other features of the invention are set out in the claims.

### BRIEF DESCRIPTION OF DRAWINGS

FIG. 1 is a block diagram of a memory device according to one or more implementations.
FIG. 2 is a diagram illustrating a configuration of a memory device including a plurality of cell layers, according to one or more implementations.
FIG. 3 is a cross-sectional view of a memory device according to one or more implementations.
FIG. 4A is a circuit diagram of a memory device according to one or more implementations.
FIG. 4B is a circuit diagram of a memory device according to one or more implementations.
FIG. 4C is a circuit diagram of a memory device according to one or more implementations.
FIG. 5 is a circuit diagram of a first string according to one or more implementations.
FIG. 6 is a circuit diagram of a pass transistor circuit connected between a plurality of wordlines and a voltage generator, according to one or more implementations.
FIG. 7 is a diagram illustrating a program speed difference between cell layers, according to one or more implementations.
FIG. 8A is a diagram illustrating a configuration to control a forcing voltage based on a program speed difference between a first cell layer and a second cell layer, according to one or more implementations.
FIG. 8B is a diagram illustrating a configuration to control a forcing voltage based on a program speed difference between a third cell layer and a fourth cell layer, according to one or more implementations.
FIG. 9 is a diagram illustrating a program speed difference between a first cell layer and a third cell layer, according to one or more implementations.
FIG. 10 is a diagram illustrating a configuration to control a wordline voltage based on a program speed difference between a first cell layer and a third cell layer, according to one or more implementations.
FIG. 11A is a diagram illustrating a first leakage current leaking to a common source line in a first cell layer, according to one or more implementations.
FIG. 11B is a diagram illustrating a second leakage current leaking to a common source line in a third cell layer, according to one or more implementations.
FIG. 12 is a diagram illustrating a configuration to control a common source line voltage based on a difference in leakage current between a first cell layer and a third cell layer, according to one or more implementations.
FIG. 13 is a cross-sectional view of a memory device according to one or more implementations.
FIG. 14 is a cross-sectional view of a memory device including a plurality of stacked cell layers, according to one or more implementations.
FIG. 15 is a cross-sectional view of a memory device including a plurality of stacked cell layers, according to one or more implementations.
FIG. 16 is a cross-sectional view of a memory device including a first cell layer to a sixth cell layer, according to one or more implementations.

### DETAILED DESCRIPTION

Hereinafter, one or more implementations will be described with reference to the accompanying drawings.

The term "first," "second," or the like used herein may modify various elements regardless of the order and/or priority thereof, and is used only for distinguishing one element from another element, without limiting one or more implementations.

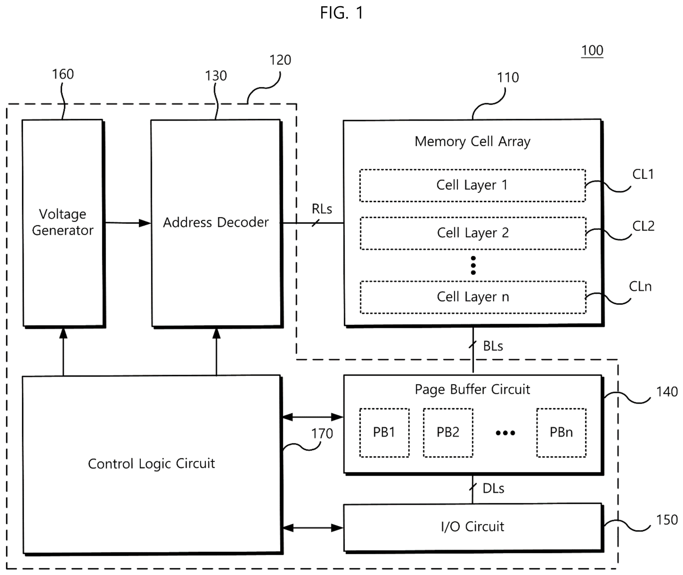

FIG. 1 is a block diagram of a memory device according to one or more implementations.

Referring to FIG. 1, a memory device 100 according to some implementations may include a memory cell array 110 and peripheral circuitry 120. The peripheral circuitry 120 may include an address decoder 130, a page buffer circuit 140, an input/output (I/O) circuit 150, a voltage generator 160, and a control logic circuit 170.

The memory cell array 110 may include a plurality of memory blocks. Each memory block may have a two-dimensional structure or a three-dimensional structure. In a memory block having a two-dimensional structure (or a horizontal structure), the memory cells may be formed in a horizontal direction with respect to a substrate. In a memory block having a three-dimensional structure (or a vertical structure), the memory cells may be formed in a direction, perpendicular to the substrate.

The memory cell array 110 may include a plurality of cell layers CL1 to CL1n. Each of the plurality of cell layers CL1 to CL1n may be formed on different wafers. For example, each of the plurality of cell layers CL1 to CL1n may be formed on different chips, and the chips on which the cell layers are formed may be connected to each other by a bonding method.

For example, the first cell layer CL1 and the second cell layer CL2 may be formed on different wafers that are stacked. For example, the second cell layer CL2 may be formed on a wafer stacked on a wafer on which the first cell layer CL1 is formed.

The address decoder 130 may be connected to the memory cell array 110 through row lines RLs. The row lines RLs may include string select lines, ground select lines, and wordlines.

The page buffer circuitry 140 may be connected to the memory cell array 110 through bitlines BLs. The page buffer circuitry 140 may temporarily store data to be programmed in a selected page or data read from the selected page.

The page buffer circuit 140 may include a plurality of page buffers PB1 to PBn. Each of the plurality of page buffers PB1 to PBn according to one or more implementations may correspond to a plurality of cell layers CL1 to CL1n.

For example, the first page buffer PB1 may correspond to the first cell layer CL1. For example, the first page buffer PB1 may be connected to a string included in the first cell layer CL1. The string may be understood as a set of memory cells connected to a specific bitline.

In addition, for example, the second page buffer PB2 may correspond to the second cell layer CL2. For example, the second page buffer PB2 may be connected to a string included in the second cell layer CL2.

According to one or more implementations, each of the plurality of page buffers PB1 to PBn may perform core operations on a plurality of cell layers CL1 to CL1n, under the control of control logic circuit 170.

The core operation may be understood as at least one of an erase operation, a program operation, a verify operation, or a read operation on a memory cell.

The I/O circuit 150 may be internally connected to the page buffer circuitry 140 through data lines DLs and externally connected to the memory controller through I/O lines.

The voltage generator 160 may generate various voltages required for the memory device 100 to operate. For example, the voltage generator 160 may be configured to generate various voltages provided to row lines RLs, bitlines BLs, or common source lines based on the operation of the memory device 100, such as a plurality of program voltages, a plurality of program verify voltages, a plurality of pass voltages, a plurality of forcing voltages, a plurality of read voltages, a plurality of read pass voltages, a plurality of erase voltages, or the like.

The control logic circuit 170 may control the overall operation of the memory device 100 in response to commands and/or addresses provided from the outside of the memory device 100.

The control logic circuit 170 may be electrically connected to the page buffer circuit 140 and/or the memory cell array 110.

The control logic circuit 170 may perform core operations on at least a portion of the plurality of cell layers CL1 to CLn. For example, the control logic circuit 170 may control the page buffer circuit 140 to perform a program operation and/or a read operation on at least a portion of the plurality of cell layers CL1 to CLn.

According to one or more implementations, the control logic circuit 170 may perform core operations on two cell layers formed adjacent to each other, among the plurality of cell layers CL1 to CLn.

The control logic circuit 170 may perform core operations on a first cell layer CL1 and a second cell layer CL2, among the plurality of cell layers CL1 to CLn stacked adjacent to each other.

For example, the control logic circuit 170 may perform core operations on the first cell layer CL1 through a first page buffer PB1. The control logic circuit 170 may perform core operations on the second cell layer CL2 through a second page buffer PB2.

Each of the page buffers PB1 to PBn may be connected to a page of a specified size in the memory cell array 110. The page may be understood as a set of memory cells connected to a specific row line (or wordline). Further, a size of the page may be understood as the number of memory cells connected to a specific row line (or wordline).

For example, each of the page buffers PB1 to PBn may be connected to a specified number of memory cells (for example, 8KB) connected to a specific wordline (or row line).

Referring to the above-described configurations, the control logic circuit 170 according to one or more implementations may perform core operations on the two stacked cell layers CL1 and CL2 using different page buffers PB1 and PB2.

Each of the different page buffers PB1 and PB2 may be connected to memory cells corresponding to the specified page size (or the number of memory cells).

As a result, the memory device 100 according to one or more implementations may increase a page size controlled by the core operations on two adjacent cell layers CL1 and CL2, among the plurality of stacked cell layers CL1 to CLn.

In addition, according to one or more implementations, the control logic circuit 170 may control a core operation on each cell layer based on cell characteristics of each cell layer.

For example, the control logic circuit 170 may control the magnitude of voltages, applied to different cell layers during operations, to vary based on the cell characteristics of each layer.

In addition, for example, the control logic circuit 170 may control timing and/or duration of voltage application to be different for operations on different cell layers, based on specific cell characteristics of each layer.

As a result, the memory device 100 according to one or more implementations may compensate for differences in characteristics of each of the plurality of cell layers CL1 to CLn.

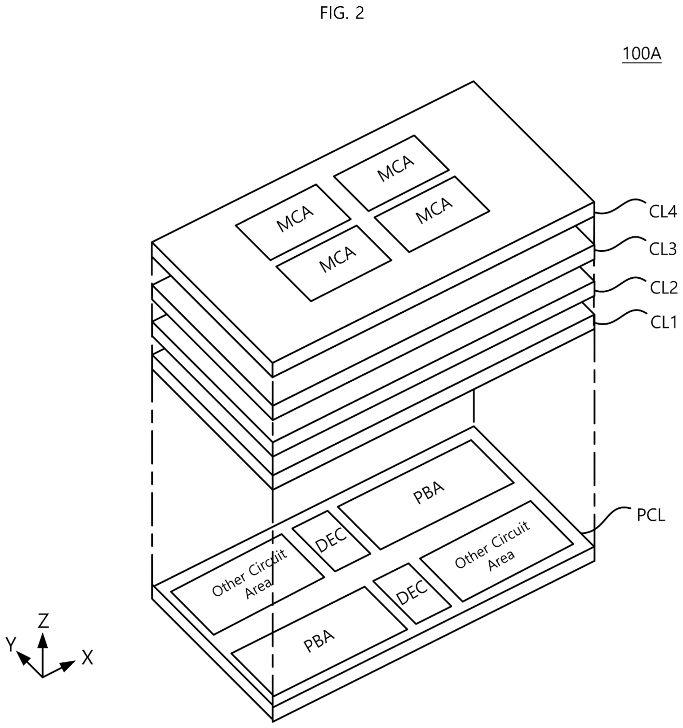

FIG. 2 is a diagram illustrating a configuration of a memory device including a plurality of cell layers, according to one or more implementations.

Referring to FIG. 2, a memory device 100A according to one or more implementations may include a first cell layer CL1 to a fourth cell layer CL4, and a peripheral circuit layer PCL.

The memory device 100A illustrated in FIG. 2 may be understood as an example of the memory device 100 illustrated in FIG. 1. Therefore, the same or substantially the same components are represented by the same reference numerals, and redundant descriptions will be omitted to avoid repetition.

The memory device 100A may include a peripheral circuit layer PCL stacked in a vertical direction (for example, a Z-direction), a first cell layer CL1, a second cell layer CL2, a third cell layer CL3, and a fourth cell layer CL4.

According to one or more implementations, the peripheral circuit layer PCL may include the peripheral circuitry 120 of FIG. 1.

For example, the peripheral circuit layer PCL may include a row decoder area DEC, a page buffer area PBA, and an other-circuit area OCA. The address decoder 130 of FIG. 1 may be disposed in the row decoder area DEC. The page buffer circuit 140 of FIG. 1 may be disposed in the page buffer area PBA. The control logic circuit 170, the input/output circuit 150, and/or the voltage generator 160 of FIG. 1 may be disposed in the other-circuit area.

Each of the first cell layer CL1 and the fourth cell layer CL4 may include a memory cell area MCA. At least a portion of the memory cell array 110 of FIG. 1 may be disposed in the memory cell area MCA of each of the first cell layer CL1 to the fourth cell layer CL4.

According to one or more implementations, the peripheral circuit layer PCL and the first cell layer CL1 to the fourth cell layer CL4 may be connected to each other by a bonding method.

For example, the peripheral circuit layer PCL and the first cell layer CL1 to the fourth cell layer CL4 may be manufactured using different wafers and then bonded to each other.

For example, the first cell layer CL1 and the second cell layer CL2 may be manufactured using different wafers and then bonded to each other. The third cell layer CL3 and the fourth cell layer CL4 may be manufactured using different wafers and then bonded to each other. A structure, in which the first cell layer CL1 and the second cell layer CL2 are combined, and a structure, the third cell layer CL3 and the fourth cell layer CL4 are combined, may be bonded to each other.

The peripheral circuit layer PCL may be bonded to a structure in which the first cell layer CL1 and the fourth cell layer CL4 are combined. Thus, the peripheral circuit layer PCL may be connected to a plurality of memory cells included in the first cell layer CL1 to the fourth cell layer CL4.

According to one or more other implementations, the third cell layer CL3 and the fourth cell layer CL4 may be omitted. For example, the peripheral circuit layer PCL may be connected to the first cell layer CL1 and the second cell layer CL2 bonded to each other.

According to one or more implementations, the control logic circuit 170 may perform core operations on two cell layers formed adjacent to each other, among the stacked first cell layer CL1 and the fourth cell layer CL4.

The control logic circuit 170 is configured to perform core operations on the first cell layer CL1 and the second cell layer CL2 stacked adjacent to each other, among the stacked first to fourth cell layers CL1 to CL4.

The control logic circuit 170 may perform core operations on the first cell layer CL1 through the first page buffer PB1. In addition, the control logic circuit 170 may perform core operations on the second cell layer CL2 through the second page buffer PB2.

Referring to the above-described configurations, the control logic circuit 170 according to one or more implementations performs core operations on the two stacked cell layers CL1 and CL2 using different page buffers PB1 and PB2.

Each of the page buffers PB1 to PBn may be connected to a corresponding number of memory cells, defined by a specified page size (for example, 8KB) or the number of memory cells, within each cell layer.

Accordingly, the memory device 100A according to one or more implementations may increase the page size controlled by the core operations on the two cell layers CL1 and CL2 stacked adjacent to the peripheral circuit layer PCL.

Memory cells disposed in different cell layers may have different cell characteristics.

For example, the memory cells disposed in the first cell layer CL1 and the memory cells disposed in the third cell layer CL3 may have different cell characteristics. For example, a core operation speed of the memory cells disposed in the first cell layer CL1 and a core operation speed of the memory cells in the third cell layer CL3 may be different from each other.

For example, a length of wordlines electrically connecting memory cells disposed in the second cell layer CL2 to the address decoder 130 disposed in the peripheral circuit layer PCL may be different from a length of wordlines electrically connecting memory cells disposed in the fourth cell layer CL4 to the address decoder 130. For example, the difference in wordline lengths may result in variations in loading characteristics.

The control logic circuit 170 according to one or more implementations may control a voltage applied in an operation on each cell layer based on the characteristics of each cell layer to compensate for such differences in the characteristics of each cell layer.

As a result, the differences in characteristics of memory cells formed on different cell layers may be compensated for, thereby improving the reliability of the core operation of the memory device 100A.

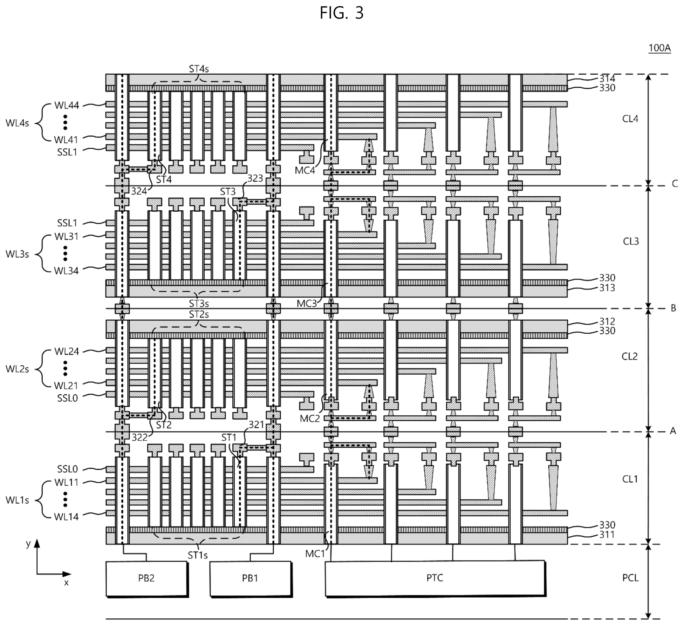

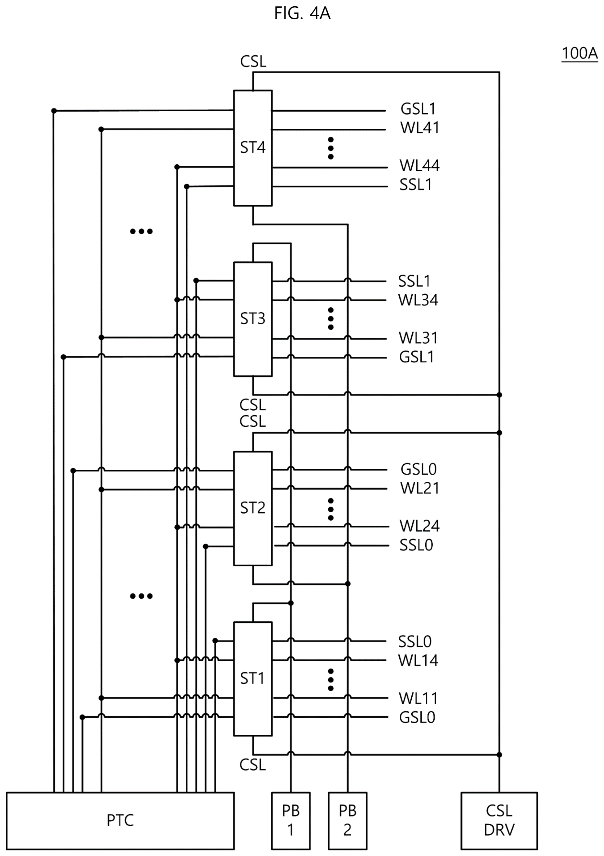

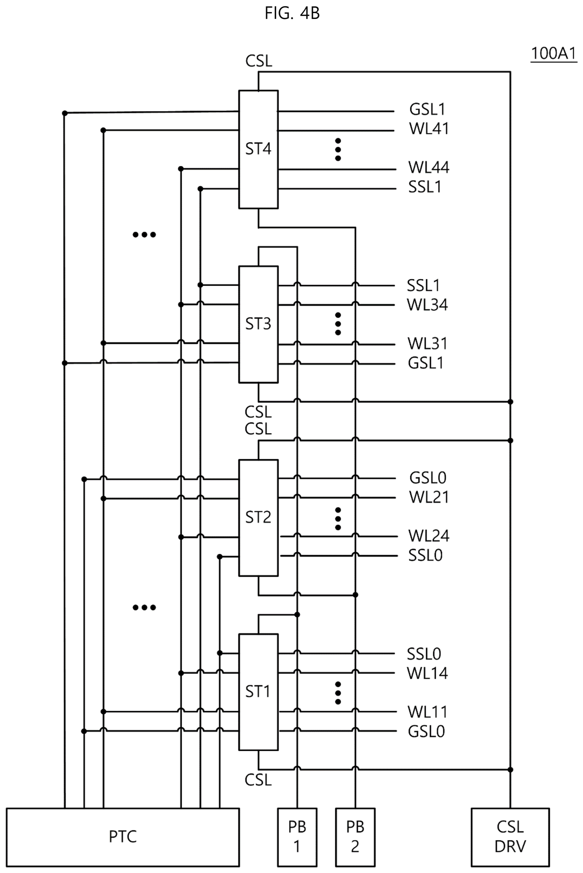

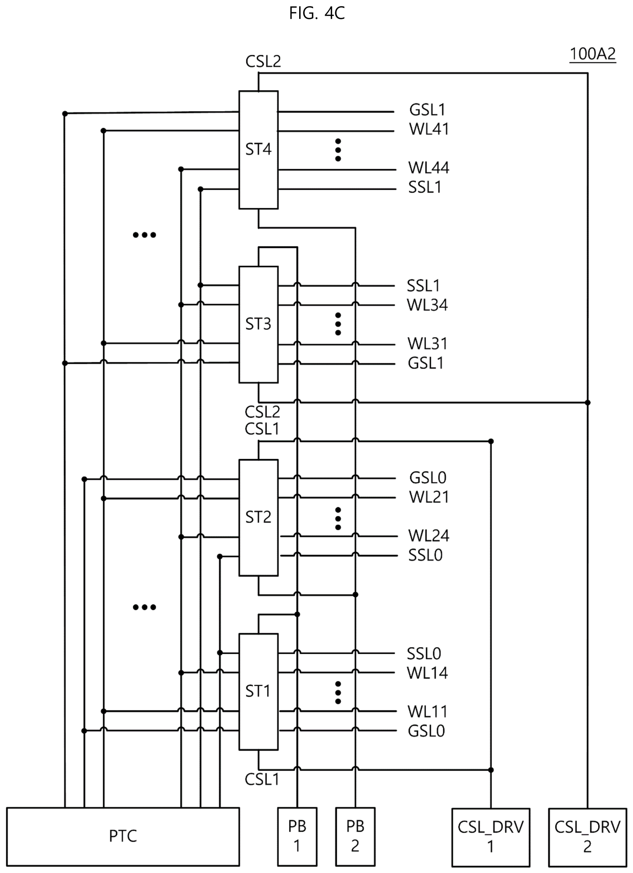

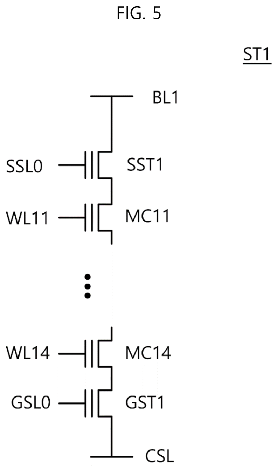

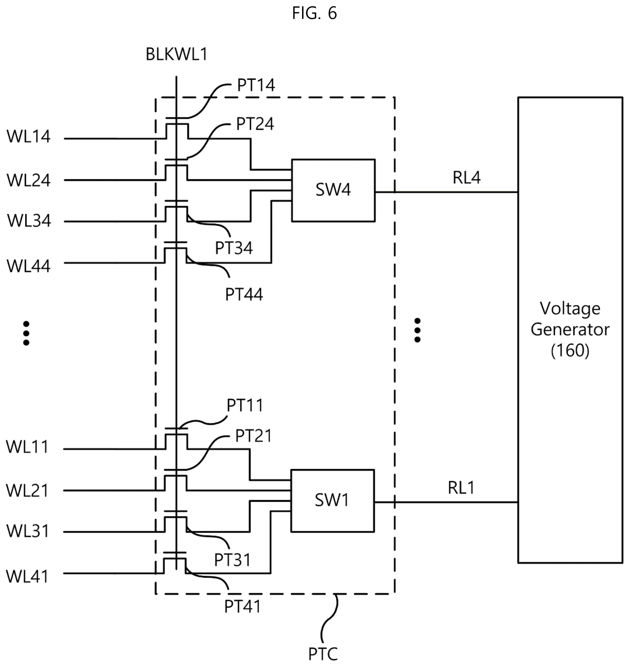

FIG. 3 is a cross-sectional view of a memory device according to one or more implementations. FIG. 4A is a circuit diagram of a memory device according to one or more implementations. FIG. 4B is a circuit diagram of a memory device according to one or more implementations. FIG. 4C is a circuit diagram of a memory device according to one or more implementations. FIG. 5 is a circuit diagram of a first string according to one or more implementations. FIG. 6 is a circuit diagram of a pass transistor circuit connected between a plurality of wordlines and a voltage generator, according to one or more implementations.

Referring to FIGS. 3 and 4A, a memory device 100A according to one or more implementations may include a peripheral circuit layer PCL, a first cell layer CL1, a second cell layer CL2, a third cell layer CL3, and a fourth cell layer CL4.

The memory device 100A illustrated in FIGS. 3 and 4a may be understood as an example of the memory device 100 illustrated in FIG. 1. Therefore, the same or substantially the same components are represented by the same reference numerals, and redundant descriptions will be omitted to avoid repetition.

For example, the memory device 100A may include a peripheral circuit layer PCL, a first cell layer CL1, a second cell layer CL2, a third cell layer CL3, and a fourth cell layer CL4 stacked on top of each other.

The peripheral circuit layer PCL may include the peripheral circuit 120 of FIG. 1. The peripheral circuit layer PCL may include a pass transistor circuit PTC, a first page buffer PB1, and a second page buffer PB2.

The pass transistor circuit PTC may be included in the address decoder 130 of FIG. 1. The first page buffer PB1 and the second page buffer PB2 may be included in the page buffer circuit 140 of FIG. 1. For example, the peripheral circuit layer PCL may be referred to as a peripheral circuit region PERI.

The peripheral circuit layer PCL and the first cell layer CL1 may be connected each other by a bonding method.

The memory device 100A may include a first cell layer CL1 and a fourth cell layer CL4 stacked in a first direction (for example, Y-direction) on the peripheral circuit layer PCL. Each of the first cell layer CL1 to the fourth cell layer CL4 may include a plurality of memory cells.

For example, the memory device 100A may include a first cell layer CL1 stacked on a peripheral circuit layer PCL.

For example, the first cell layer CL1 may include a plurality of first wordlines WL1s and a first string select lines SSLO stacked in the first direction (for example, Y- direction).

The plurality of first wordlines WL1s and the first string select lines SSLO may each have a shape extending in a second direction (for example, X-direction).

In addition, the plurality of first wordlines WL1s and the first string select line SSLO may have shapes extending in a second direction (for example, X-direction) with different lengths. For example, the first string select line SSLO may extend in the second direction (for example, X-direction) with a relatively smaller length compared to a (1-1)-th wordline WL11 (also referred to as a first wordline of a first group of wordlines). Similarly, the (1-1)-th wordline WL11 may extend in the second direction (for example, X-direction) with a relatively smaller length compared to a (1-4)-th wordline WL14 (also referred to as a fourth wordline of a first group of wordlines).

In addition, the plurality of first wordlines WL1s may be connected to the pass transistor circuit PTC of the peripheral circuit layer PCL. For example, the (1-1)-th wordline WL11 may be connected to the pass transistor circuit PTC through a first metal contact MC1.

The first cell layer CL1 may include a plurality of first strings ST1s extending in the first direction (for example, Y-direction), which is substantially perpendicular to the plurality of first wordlines WL1s.

The plurality of first strings ST1s may extend in the first direction (for example, Y-direction) on the first substrate 311 and the common source line 330.

According to one or more implementations, among the plurality of first strings ST1s, a first string ST1 may be connected to the first page buffer PB1 through a first metal wiring 321. Accordingly, the first metal wiring 321 may be referred to as a first bitline BL1 connected to the first string ST1.

Referring to FIG. 5, the first string ST1 according to one or more implementations may include a plurality of transistors connected in series between the first bitline BL1 and the common source line CSL.

For example, the first string ST1 may include a first string select transistor SST1 connected to a first bitline BL1. The first string select transistor SST1 may operate based on a signal applied through a first string select line SSLO.

In addition, the first string ST1 may include a first ground select transistor GST1 connected to the common source line CSL. The first ground select transistor GST1 may operate based on a signal applied through a first ground select line GSL0.

In addition, the first string ST1 may include a plurality of first memory cells MC11 to MC14 connected in series between the first string select transistor SST1 and the first ground select transistor GST1. Transistors, respectively corresponding to the plurality of first memory cells MC11 to MC14, may operate based on signals applied through the (1-1)-th to (1-4)-th wordlines WL11 to WL14.

In addition, the memory device 100A may include a second cell layer CL2 stacked on the first cell layer CL1.

According to one or more implementations, the second cell layer CL2 may have substantially the same shape as a mirrored version of the first cell layer CL1 with respect to a virtual line A extending in the second direction (for example, X-direction).

For example, the second cell layer CL2 may include a plurality of second wordlines WL2s and the first string select line SSL0, each extending in the second direction (for example, X-direction).

The plurality of second wordlines WL2s and the first string select line SSLO may have shapes extending in the second direction (for example, X-direction) with different lengths. For example, a (2-1)-th wordline WL21 may extend in the second direction (for example, X-direction) with a relatively smaller length compared to a (2-4)-th wordline WL24.

In addition, the plurality of second wordlines WL2s may be connected to the pass transistor circuit PTC in the peripheral circuit layer PCL.

For example, the (2-1)-th wordline WL21 may be connected to the pass transistor circuit PTC through a first metal contact MC1 and a second metal contact MC2. The first metal contact MC1 and the second metal contact MC2 may be electrically connected to each other through a bonding structure between the first cell layer CL1 and the second cell layer CL2.

The second cell layer CL2 may include a plurality of second strings ST2s extending in the first direction (for example, Y-direction), substantially perpendicular to the plurality of second wordlines WL2s.

The plurality of second strings ST2s may extend in a reverse direction of the first direction (for example, Y-direction) from a second substrate 312 and a common source line 330.

According to one or more implementations, among the plurality of second strings ST2s, a second string ST2 may be connected to the second page buffer PB2 through a second metal wiring 322. Thus, the second metal wiring 322 may be referred to as a second bitline BL2 connected to the second string ST2.

The second string ST2 may have substantially the same shape as the first string ST1 illustrated in FIG. 5. For example, the second string ST2 may include a plurality of transistors (or memory cells) connected in series between the second bitline BL2 and the common source line CSL.

In addition, the memory device 100A may include a third cell layer CL3 stacked on the second cell layer CL2.

According to one or more implementations, the third cell layer CL3 may have a substantially the same shape as a mirrored version of the second cell layer CL2 with respect to a virtual line B extending in the second direction (for example, X-direction).

For example, the third cell layer CL3 may include a plurality of third wordlines WL3s and a second string select line SSL1, each extending in the second direction (for example, X-direction).

The plurality of third wordlines WL3s and the second string select line SSL1 may have shapes extending in the second direction (for example, X-direction) with different lengths. For example, a (3-1)-th wordline WL31 may extend in the second direction (for example, X-direction) with a relatively smaller length compared to a (3-4)-th wordline WL34.

In addition, the plurality of third wordlines WL3s may be connected to the pass transistor circuit PTC of the peripheral circuit layer PCL.

For example, the (3-1)-th wordline WL31 may be connected to the pass transistor circuit PTC through a first metal contact MC1, a second metal contact MC2, and a third metal contact MC3. The first to third metal contacts MC1 to MC3 may be electrically connected to each other through a bonding structure formed from the first cell layer CL1 to the third cell layer CL3.

The third cell layer CL3 may include a plurality of third strings ST3s extending in the first direction (for example, Y-direction), substantially perpendicular to the plurality of third wordlines WL3s.

The plurality of third strings ST3s may extend in the first direction (for example, Y-direction) from the third substrate 313 and the common source line 330.

According to one or more implementations, among the plurality of third strings ST3s, a third string ST3 may be connected to the first page buffer PB1 through the third metal wiring 323. Thus, the third metal wiring 323 may be referred to as a third bitline BL3 connected to the third string ST3.

The third string ST3 may have substantially the same configuration as the first string ST1 illustrated in in FIG. 5. For example, the third string ST3 may include a plurality of transistors or memory cells connected in series between the third bitline BL3 and the common source line CSL.

In addition, the memory device 100A may include a fourth cell layer CL4 stacked on the third cell layer CL3.

According to one or more implementations, a fourth cell layer CL4 may have substantially the same shape as a mirrored version of the third cell layer CL3 with respect to a virtual line C extending in the second direction (for example, X-direction).

For example, the fourth cell layer CL4 may include a plurality of fourth wordlines WL4s and a second string select line SSL1, each extending in the second direction (for example, X-direction).

The plurality of fourth wordlines WL4s and the second string select line SSL1 may have shapes extending in the second direction (for example, X-direction) with different lengths. For example, a (4-1)-th wordline WL41 may extend in the second direction (for example, X-direction) with a relatively smaller length compared to a (4-4)-th wordline WL44.

In addition, the plurality of fourth wordlines WL4s may be connected to the pass transistor circuit PTC of the peripheral circuit layer PCL.

For example, the (4-1)-th wordline WL41 may be connected to the pass transistor circuit PTC through a first metal contact MC1, a second metal contact MC2, a third metal contact MC3, and a fourth metal contact MC4. The first to fourth metal contacts MC1 to MC4 may be electrically connected to each other through a bonding structure formed from the first cell layer CL1 to the fourth cell layer CL4.

The fourth cell layer CL4 may include a plurality of fourth strings ST4s extending in the first direction (for example, Y-direction), substantially perpendicular to the plurality of fourth wordlines WL4s.

The plurality of fourth strings ST4s may extend in a reverse direction of the first direction (for example, Y-direction) from the fourth substrate 314 and the common source line 330.

According to one or more implementations, among the plurality of fourth strings ST4s, a fourth string ST4 may be connected to the second page buffer PB2 through a fourth metal wiring 324. Thus, the fourth metal wiring 324 may be referred to as a fourth bitline BL4 connected to the fourth string ST4.

The fourth string ST4 may have substantially the same configuration as the first string ST1 illustrated in FIG. 5. For example, the fourth string ST4 may include a plurality of transistors (or memory cells) connected in series between the fourth bitline BL4 and the common source line CSL.

While each of the cell layers CL1, CL2, CL3, and CL4 has been described as including four wordlines, this is just an example and the number of wordlines included in each cell layer is not limited thereto.

According to one or more implementations, at least a portion of the common source lines 330 included in each of the first to fourth cell layers CL1 to CL4 may be implemented as a single wiring. For example, the common source lines 330 included in the second and third cell layers CL2 and CL3 may be implemented as a single wiring.

In addition, referring to FIG. 4A, the common source lines 330 included in each of the first to fourth cell layers CL1 to CL4 may be connected to a common source line driver CSL_DRV.

Referring to FIGS. 3 and 4A, the first page buffer PB1 according to one or more implementations is connected to the first string ST1 and the third string ST3.

For example, the first page buffer PB1 may be connected to the first string ST1 of the first cell layer CL1 through the first metal wiring 321 (or the first bitline BL1). In addition, the first page buffer PB1 may be connected to the third string ST3 of the third cell layer CL3 through the third metal wiring 323 (or the third bitline).

In addition, the second page buffer PB2 is connected to a second string ST2 and a fourth string ST4.

For example, the second page buffer PB2 may be connected to the second string ST2 of the second cell layer CL2 through the second metal wiring 322 (or the second bitline). In addition, the second page buffer PB2 may be connected to the fourth string ST4 of the fourth cell layer CL4 through the fourth metal wiring 324 (or the fourth bitline).

According to one or more implementations, the control logic circuit 170 is configured to control the first page buffer PB1 to perform a core operation on the first cell layer CL1 and/or the third cell layer CL3.

For example, the control logic circuit 170 may control the first page buffer PB1 to apply a voltage to the first string ST1 through the first bitline BL1 (or the first metal wiring 321) during the core operation on the first cell layer CL1.

In addition, the control logic circuit 170 may control the first page buffer PB1 to apply a voltage to the third string ST3 through the third metal wiring 323 (or the third bitline) during the core operation on the third cell layer CL3.

According to one or more implementations, the control logic circuit 170 is configured to control the second page buffer PB2 to perform a core operation on the second cell layer CL2 and/or the fourth cell layer CL4.

For example, the control logic circuit 170 may control the second page buffer PB2 to apply a voltage to the second string ST2 through the second metal wiring 322 (or the second bitline) during the core operation on the second cell layer CL2.

In addition, the control logic circuit 170 may control the second page buffer PB2 to apply a voltage to the third string ST3 through the fourth metal wiring 324 (or the fourth bitline) during the core operation on the fourth cell layer CL4.

According to one or more implementations, the control logic circuit 170 may perform core operations on the first cell layer CL1 and the second cell layer CL2 using the first page buffer PB1 and the second page buffer PB2.

For example, the control logic circuit 170 may control the first page buffer PB1 to apply a voltage to the first string ST1 to perform a core operation on the first cell layer CL1.

In addition, the control logic circuit 170 may control the second page buffer PB2 to apply a voltage to the second string ST2 to perform a core operation on the second cell layer CL2.

For example, when a core operation on a structure including the first cell layer CL1 and the second cell layer CL2 is requested, the control logic circuit 170 according to one or more implementations performs the core operation using the first page buffer PB1 and the second page buffer PB2.

In addition, when a core operation on a structure including the third cell layer CL3 and the fourth cell layer CL4 is requested, the control logic circuit 170 according to one or more implementations performs the core operation using the first page buffer PB1 and the second page buffer PB2.

Each of the page buffers PB1 to PBn may be connected to a corresponding number of memory cells, defined by a specified page size (for example, 8KB) or the number of memory cells, within each cell layer.

For example, the first page buffer PB1 may be connected to memory cells corresponding to a specified page size in the first cell layer CL1. In addition, the second page buffer PB2 may be connected to memory cells corresponding to the specified page size in the second cell layer CL2.

Thus, the memory device 100A according to one or more implementations may increase a page size controlled during core operations on two adjacent stacked cell layers CL1 and CL2 and CL3 and CL4.

Referring to FIG. 4B, a first string ST1 and a second string ST2 included in a memory device 100A1 according to one or more implementations may be connected to a first source select line SSLO. The memory device 100A1 illustrated in FIG. 4B may be understood as an example of the memory device 100A illustrated in FIG. 4A.

For example, the first string ST1 and the second string ST2 may be connected to the first source select line SSLO through a single node. For example, the first string ST1 and the second string ST2 may be connected to the first source select line SSLO via a single metal wiring (or contact).

In addition, the first string ST1 and the second string ST2 according to one or more implementations may be connected to the first ground select line GSL0 through a single node. For example, the first string ST1 and the second string ST2 may be connected to the first ground select line GSL0 via a single metal wiring (or contact).

In addition, the third string ST3 and the fourth string ST4 according to one or more implementations may be connected to the second source select line SSL1.

For example, the third string ST3 and the fourth string ST4 may be connected to the second source select line SSL1 through a single node. For example, the third string ST3 and the fourth string ST4 may be connected to the second source select line SSL1 via a single metal wiring (or contact).

In addition, the third string ST3 and the fourth string ST4 according to one or more implementations may be connected to the second ground select line GSL1 through a single node. For example, the third string ST3 and the fourth string ST4 may be connected to the second ground select line GSL1 via a single metal wiring (or contact).

Referring to FIG. 4C, a first string ST1 and a second string ST2 included in a memory device 100A2 may be connected to a first common source line CSL1. The memory device 100A2 illustrated in FIG. 4C may be understood as an example of the memory device 100A illustrated in FIG. 4A.

For example, the first string ST1 and the second string ST2 may be connected to the first common source line CSL1 through a single node. For example, the first string ST1 and the second string ST2 may be connected to the first common source line CSL1 via a single metal wiring (or contact).

The first string ST1 and the second string ST2 may be connected to a first common source line driver CSL_DRV1 through the first common source line CSL1.

In addition, the third string ST3 and the fourth string ST4 according to one or more implementations may be connected to the second common source line CSL2.

For example, a third string ST3 and a fourth string ST4 may be connected to a second common source line CSL2 through a single node. For example, the third string ST3 and the fourth string ST4 may be connected to the second common source line CSL2 via a single metal wiring (or contact).

The third string ST3 and the fourth string ST4 may be connected to a second common source line driver CSL_DRV2 through the second common source line CSL2.

Referring to the above-described configurations, the control logic circuit 170 may independently control the first common source line CSL1 and the second common source line CSL2 using separate common source line drivers CSL_DRV1 and CSL_DRV2.

For example, the control logic circuit 170 according to one or more implementations may independently control a common source line voltage for the first and second strings ST1 and ST2 and a common source line voltage for the third and fourth strings ST3 and ST4 using separate common source line drivers CSL_DRV1 and CSL_DRV2.

In addition, referring to FIG. 6, a pass transistor circuit PTC according to one or more implementations may include a plurality of pass transistors PT11 to PT44 connected to a plurality of wordlines included in each cell layer.

The pass transistor circuit PTC may include switch circuits SW1 to SW4 connected to at least a portion of the plurality of pass transistors PT11 to PT44. Alternatively, the switch circuits SW1 to SW4 may be configured as a single circuit including a single set of switches, but one or more implementations are not limited thereto.

The pass transistor circuit PTC may include a (1-1)-th pass transistor PT11 (also referred to as a first pass transistor of a first group of pass transistors) having one end connected to a (1-1)-th wordline WL11 (also referred to as a first wordline of a first group of wordlines). The pass transistor PTC may also include a (2-1)-th pass transistor PT21 (also referred to as a first pass transistor of a second group of pass transistors) having one end connected to a (2-1)-th wordline WL21 (also referred to as a first wordline of a second group of wordlines), a (3-1)-th pass transistor PT31 (also referred to as a first pass transistor of a third group of pass transistors) having one end connected to a (3-1)-th wordline WL31 (also referred to as a first wordline of a third group of wordlines), and a (4-1)-th pass transistor PT41 (also referred to as a first pass transistor of a fourth group of pass transistors) having one end connected to a (4-1)-th wordline WL41 (also referred to as a first wordline of a fourth group of wordlines). The pass transistor circuit PTC may further include a first switch circuit SW1 connected to (1-1)-th pass transistor PT11 (also referred to as a first pass transistor of a first group of pass transistors) to the (4-1)-th pass transistor PT41 (also referred to as a first pass transistor of a fourth group of pass transistors).

The other ends of the (1-1)-th pass transistor PT11 to the (4-1)-th pass transistor PT41 may be connected to a first row line RL1 through the first switch circuit SW1.

Accordingly, the control logic circuit 170 according to an one or more implementations may control the first switch circuit SW1 to control a voltage applied to the (1-1)-th pass transistor PT11 to the (4-1)-th pass transistor PT41.

For example, the control logic circuit 170 may control the first switch circuit SW1 to apply a voltage, transferred from the first row line RL1, to at least one of the (1-1)-th pass transistor PT11 to the (4-1)-th pass transistor PT41.

For example, the control logic circuit 170 according to one or more implementations may control the first switch circuit SW1 to apply a voltage (for example, a pass voltage) for a core operation to one of the (1-1)-th wordline WL11 to the (1-4)-th wordline WL14.

The pass transistor circuit PTC may include a (1-4)-th pass transistor PT14 having a first end connected to the (1-4)-th wordline WL14. The pass transistor PTC may include a (2-4)-th pass transistor PT24 connected to a (2-4)-th wordline (WL24), a (3-4)-th pass transistor PT34 connected to a (3-4)-th wordline WL34, and a (4-4)-th pass transistor PT44 connected to a (4-4)-th wordline WL44. In addition, the pass transistor circuit PTC may include a fourth switch circuit SW4 connected to the other ends of the (1-4)-th wordline WL14 to the (4-4)-th wordline WL44.

The other ends of the (1-4)-th pass transistor PT14 to the (4-4)-th pass transistor PT44 may be connected to a fourth row line RL4 through the fourth switch circuit SW4.

Thus, the control logic circuit 170 according to one or more implementations may control the fourth switch circuit SW4 to control a voltage applied to the (4-1)-th pass transistor PT41 to the (4-4)-th pass transistor PT44.

For example, the control logic circuit 170 may control the fourth switch circuit SW4 to apply a voltage, transferred from the fourth row line RL4, to at least one of the (4-1)-th pass transistor PT41 to the (4-4)-th pass transistor PT44.

For example, the control logic circuit 170 according to one or more implementations may control the fourth switch circuit SW4 to apply a voltage (for example, a pass voltage) for a core operation to one of a (4-1)-th wordline WL41 to a (4-4)-th wordline WL44.

Gate electrodes of the plurality of pass transistors PT1 to PT4 may be connected to a block wordline BLKWL1.

For example, a (1-1)-th pass transistor (PT11) may provide a voltage, received from the voltage generator 160 through the first row line RL1, to the (1-1)-th wordline WL11 in response to a voltage level of the block wordline BLKWL1.

Referring to the above-described configurations, wordlines corresponding to each other in the first to fourth cell layers CL1 to CL4 may be simultaneously driven by voltages transmitted from the same row line.

Thus, the pass transistor circuit PTC according to one or more implementations may be implemented with a relatively smaller area, compared to a configuration in which row lines are connected wordlines of the first to fourth cell layers CL1 to CL4, respectively.

As a result, the memory device 100A according to one or more implementations may have a relatively smaller area.

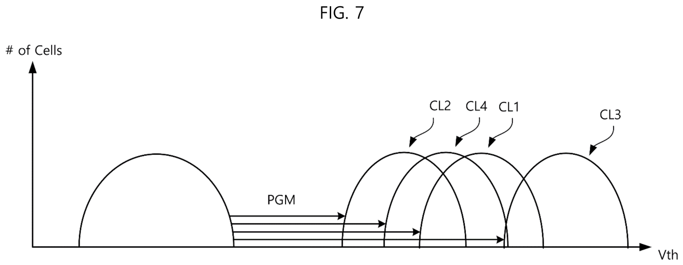

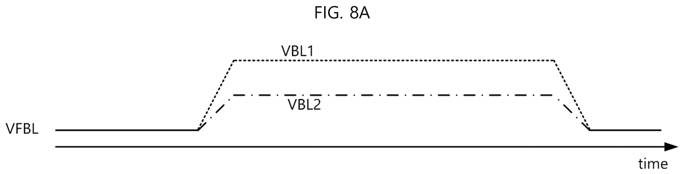

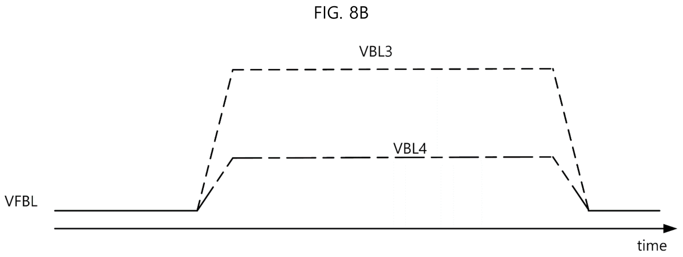

FIG. 7 is a diagram illustrating a program speed difference between cell layers, according to one or more implementations. FIG. 8A is a diagram illustrating a configuration to control a forcing voltage based on a program speed difference between a first cell layer and a second cell layer, according to one or more implementations. FIG. 8B is a diagram illustrating a configuration to control a forcing voltage based on a program speed difference between a third cell layer and a fourth cell layer, according to one or more implementations.

Referring to FIGS. 7, 8A, and 8B, the control logic circuit (170) according to one or more implementations may control the magnitude of a forcing voltage VFBL applied through a bitline of each cell layer based on the characteristics of adjacent stacked cell layers.

For example, when adjacent stacked cell layers have different characteristics, the control logic circuit 170 may apply different magnitudes of forcing voltages VFBL to each cell layer through different page buffers.

Referring to FIG. 7, the first cell layer CL1 and the second cell layer CL2 may exhibit different characteristics during a program operation.

For example, memory cells in the first cell layer CL1 may be programmed earlier than memory cells in the second cell layer CL2. For example, a program speed of the memory cells in the first cell layer CL1 may be higher than a program speed of the memory cells in the second cell layer CL2.

In addition, a change in threshold voltage of the memory cells in the first cell layer CL1 depending on the same program voltage may be greater than a change in threshold voltage of the memory cells in the second cell layer CL2. A "change in threshold voltage" of the memory cells may also be referred to as a "magnitude of the threshold voltage shift" of the memory cells. For example, when the same program voltage is applied to the first cell layer CL1 and the second cell layer CL2, the change in threshold voltage of the memory cells in the first cell layer CL1 may be greater than the change in threshold voltage of the memory cells in the second cell layer CL2.

Referring to FIG. 7 and FIG. 8A, a control logic circuit 170 according to one or more implementations may apply a first forcing voltage VBL1 to the first cell layer CL1 through a first page buffer PB1.

For example, the control logic circuit 170 may apply the first forcing voltage VBL1 through a first bitline BL1, connected to the first page buffer PB1, to the first cell layer CL1 that exhibits a relatively large change in threshold voltage depending on a program voltage. As a result, the control logic circuit 170 may reduce the change in threshold voltage of memory cells in the first cell layer CL1 depending on the program voltage.

In addition, the control logic circuit 170 may apply a second forcing voltage VBL2, smaller than the first forcing voltage VBL1, to the second cell layer CL2 through a second page buffer PB2.

For example, the control logic circuit 170 may apply the second forcing voltage VBL2, relatively smaller than the first forcing voltage VBL1, through a second bitline connected to the second page buffer PB2 to the second cell layer CL2 that exhibits a relatively small change in threshold voltage depending on the program voltage.

As a result, the control logic circuit 170 may reduce the change in threshold voltage of memory cells in the second cell layer CL2 depending on the program voltage, such that the change in threshold voltage of the memory cells in the second cell layer CL2 is smaller than the change in threshold voltage of the memory cells in the first cell layer CL1.

According to the above-described configurations, the control logic circuit 170 according to one or more implementations may compensate for characteristic differences (for example, a program speed) between the first cell layer CL1 and the second cell layer CL2.

Referring to FIG. 7, characteristics of a third cell layer CL3 and a fourth cell layer CL4 may differ during a program operation.

For example, memory cells in the third cell layer CL3 may be programmed earlier than memory cells in the fourth cell layer CL4. For example, a program speed of the memory cells in the third cell layer CL3 may be higher than a program speed of the memory cells in the fourth cell layer CL4.

In addition, a change in threshold voltage of the memory cells in the third cell layer CL3 depending on the program voltage may be relatively greater than a change in threshold voltage of the memory cells in the fourth cell layer CL4. For example, when the same program voltage is applied to both the third and fourth cell layers CL3 and CL4, the change in threshold voltage of the memory cells in the third cell layer CL3 may be greater than the change in threshold voltage of the memory cells in the fourth cell layer CL4.

Referring to FIG. 7 and FIG. 8B, the control logic circuit 170 according to one or more implementations may apply a third forcing voltage VBL3 to the third cell layer CL3 through the first page buffer PB1.

For example, the control logic circuit 170 may apply a third forcing voltage VBL3 through the first bitline BL1, connected to the first page buffer PB1, to the third cell layer CL3 that exhibits a relatively large change in threshold voltage depending on a program voltage. As a result, the control logic circuit 170 may reduce the change in threshold voltage of memory cells in the third cell layer CL3 depending on the program voltage.

In addition, the control logic circuit 170 may apply a fourth forcing voltage VBL4, smaller than the third forcing voltage VBL3, to the fourth cell layer CL4 through the second page buffer PB2.

For example, the control logic circuit 170 may apply a fourth forcing voltage VBL4, smaller than the third forcing voltage VBL3, through the second bitline connected to the second page buffer PB2 to the fourth cell layer CL4 that exhibits a relatively small change in threshold voltage depending on the program voltage.

As a result, the control logic circuit 170 may reduce a change in threshold voltage of the memory cells in the fourth cell layer CL4 depending on the program voltage, such that the change in threshold voltage of the memory cells in the fourth cell layer CL4 is smaller than the change in threshold voltage of the memory cells in the third cell layer CL3.

According to the above-described configurations, the control logic circuit 170 according to one or more implementations may compensate for characteristic differences (for example, a program speed) between the third cell layer CL3 and the fourth cell layer CL4.

While characteristics that differ between cell layers have been described in terms of a program speed in FIGS. 7 to 8B, the characteristics are not limited thereto and may include other characteristics exhibited in various operations, such as a read voltage output.

For example, the control logic circuit 170 may apply a relatively higher bitline voltage during a read operation on the second cell layer CL2 (or the second string ST2), which has a relatively larger resistance, compared to the bitline voltage applied during a read operation on the first cell layer CL1 (or the first string ST1).

Referring to the above-described configurations, the control logic circuit 170 according to one or more implementations may control the magnitude of the forcing voltage VFBL, applied through a bitline of each cell layer, to be different when adjacent stacked cell layers exhibit different characteristics. Thus, the control logic circuit 170 may compensate for characteristic differences between the stacked cell layers.

With the above-described configurations, the memory device 100 according to one or more implementations may improve the reliability of core operations.

In addition, the memory device 100 may control a voltage applied to a bitline to compensate for characteristic differences between stacked cell layers. As a result, the memory device 100 may reduce overhead necessary to mitigate such differences.

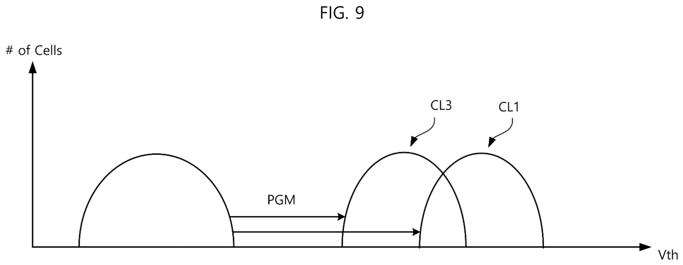

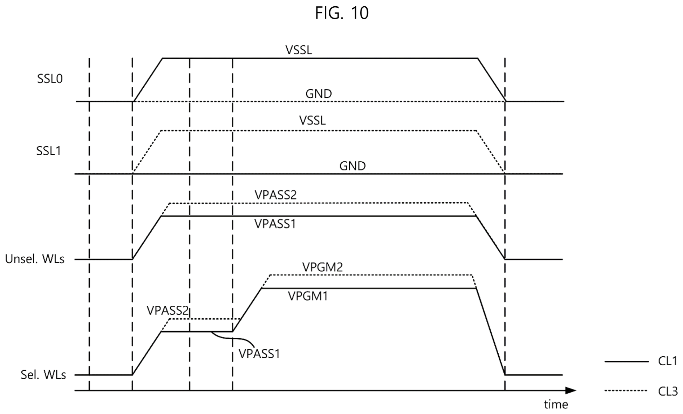

FIG. 9 is a diagram illustrating a program speed difference between a first cell layer and a third cell layer, according to one or more implementations. FIG. 10 is a diagram illustrating a configuration to control a wordline voltage based on a program speed difference between a first cell layer and a third cell layer, according to one or more implementations.

Referring to FIGS. 9 and 10, a control logic circuit 170 according to one or more implementations may control the magnitude of a voltage applied to a wordline of each cell layer, based on characteristics of the stacked cell layers.

For example, the control logic circuit 170 may control the magnitude of a voltage applied to a wordline of each cell layer to be different, based on characteristics of two cell layers among the stacked cell layers CL1 to CL4.

Referring to FIG. 9, characteristics of the first cell layer CL1 and the third cell layer CL3 may differ during a program operation.

For example, memory cells in the first cell layer CL1 may be programmed earlier than memory cells in the third cell layer CL3. For example, a program speed of the memory cells in the first cell layer CL1 may be higher than a program speed of the memory cells in the third cell layer CL3.

In addition, a change in threshold voltage of the memory cells in the first cell layer CL1 depending on a program voltage may be greater than a change in threshold voltage of the memory cells in the third cell layer CL3. For example, when the same program voltage is applied to both the first and third cell layers CL1 and CL3, the change in threshold voltage of the memory cells in the first cell layer CL1 may be greater than the change in threshold voltage of the memory cells in the third cell layer CL3.

Referring to FIGS. 9 and 10, the control logic circuit 170 according to one or more implementations may apply a first program voltage VPGM1 to a (1-1)-th wordline WL11 during a program operation on the first cell layer CL1.

For example, the control logic circuit 170 may apply a string select voltage VSSL through a first string select line SSLO during a program operation on the first cell layer CL1. A voltage of a second string select line SSL1 may be set to ground GND. Thus, the control logic circuit 170 may activate the first cell layer CL1 connected to the first string select line SSLO.

Furthermore, the control logic circuit 170 may turn on a first pass transistor PT1 connected to the (1-1)-th wordline WL11 of the pass transistor circuit PTC. For example, the control logic circuit 170 may apply a first pass voltage VPASS1 to the first pass transistor PT1 to turn on the first pass transistor PT1.

In addition, the control logic circuit 170 may apply a first program voltage VPGM1 to the (1-1)-th wordline WL11. For example, the control logic circuit 170 may apply the first program voltage VPGM1 to the (1-1)-th wordline WL11 through the first pass transistor PT1 and a first metal contact MC1.

In addition, the control logic circuit 170 according to one or more implementations may apply a second program voltage VPGM2, greater than the first program voltage VPGM1, to the (3-1)-th wordline WL31 during a program operation on the third cell layer CL3.

For example, the control logic circuit 170 may apply a string select voltage VSSL through the second string select line SSL1 during a program operation on the third cell layer CL3. A voltage of the first string select line SSLO may be set to ground GND. Thus, the control logic circuit 170 may activate the third cell layer CL3 connected to the second string select line SSL1.

Furthermore, the control logic circuit 170 may turn on the first pass transistor PT1, connected to the third to (3-1)-th wordline WL31, in the pass transistor circuit PTC.

For example, the control logic circuit 170 may apply a second pass voltage VPASS2 to the first pass transistor PT1 to turn on the first pass transistor PT1. The second pass voltage VPASS2 may have a greater value than the first pass voltage VPASS1.

In addition, the control logic circuit 170 may apply a second program voltage VPGM2, greater than the first program voltage VPGM1, to the (3-1)-th wordline WL31. For example, the control logic circuit 170 may apply the second program voltage VPGM2 to the (3-1)-th wordline WL31 through the first pass transistor PT1, the first metal contact MC1, a second metal contact MC2, and a third metal contact MC3.

For example, the control logic circuit 170 according to one or more implementations may apply a relatively high program voltage (or pass voltage) through a wordline of the third cell layer CL3 during a program operation on the third cell layer CL3 with a relatively low program speed.

Thus, the control logic circuit 170 may compensate for differences in characteristics (for example, a program speed) between the first cell layer CL1 and the third cell layer CL3.

According to one or more implementations, the control logic circuit 170 may apply the first program voltage PGM1 to the third cell layer CL3 for a relatively longer time than the time the first program voltage PGM1 is applied to the first cell layer CL1 during a program operation on the third cell layer CL3 with a relatively high program speed. Thus, the control logic circuit 170 may compensate for differences in characteristics (for example, program speed) between the first cell layer CL1 and the third cell layer CL3.

While characteristics that differ between cell layers have been described in terms of a program speed in FIGS. 9 to 10, the characteristics are not limited thereto and may include other characteristics exhibited in various operations, such as a read voltage output.

For example, the control logic circuit 170 may apply a relatively higher read voltage to the third cell layer CL3 (or the third string ST3), which is electrically farther from the peripheral circuit layer (PCL), compared to the read voltage applied during a read operation on the first cell layer CL1 (or the first string ST1).

Referring to the above-described configurations, the control logic circuit 170 according to one or more implementations may control the magnitude of a voltage (for example, a program voltage) applied through a wordline of each cell layer to be different when the stacked cell layers have different characteristics. Thus, the control logic circuit 170 may compensate for differences in characteristics between the plurality of cell layers.

With the configurations described above, the memory device 100 according to one or more implementations may improve the reliability of core operations.

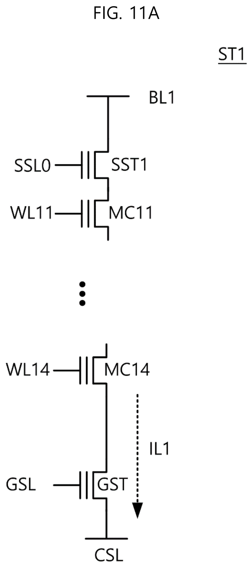

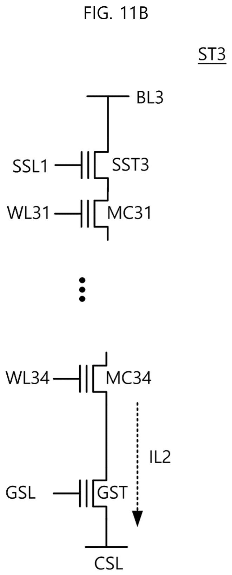

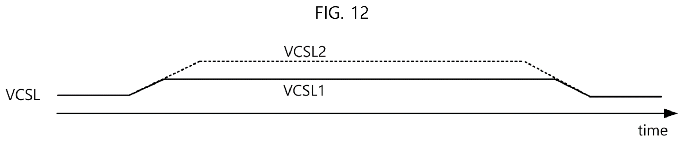

FIG. 11A is a diagram illustrating a first leakage current leaking to a common source line in a first cell layer, according to one or more implementations. FIG. 11B is a diagram illustrating a second leakage current leaking to a common source line in a third cell layer, according to one or more implementations. FIG. 12 is a diagram illustrating a configuration to control a common source line voltage based on a difference in leakage current between a first cell layer and a third cell layer, according to one or more implementations.

Referring to FIGS. 11A, 11B, and 12, a control logic circuit 170 according to one or more implementations may control the magnitude of a common source line voltage VCSL applied through a common source line CSL during a core operation on each cell layer, based on characteristics of stacked cell layers.

Referring to FIGS. 11A and 11B, leakage currents IL1 and IL2 may be generated from a plurality of memory cells toward a common source line CSL in strings ST1 and ST3 according to one or more implementations, respectively.

For example, the first leakage current IL1 may be generated from the plurality of first memory cells MC11 to MC14 toward the common source line CSL during a core operation on the first string ST1.

The second leakage current IL2 may be generated from the plurality of third memory cells MC31 to MC34 toward the common source line CSL during a core operation on the third string ST3.

The second leakage current IL2 may have a greater value than the first leakage current IL1.

Referring to FIGS. 11A, 11B, and 12, the control logic circuit 170 according to one or more implementations may apply a first common source line voltage VCSL1 to the common source line CSL during a core operation on a first cell layer CL1 (or a first string ST1).

Thus, the control logic circuit 170 may reduce a voltage difference between the plurality of first memory cells MC11 to MC14 and the common source line CSL during the core operation on the first cell layer CL1 (or the first string ST1) to reduce the first leakage current IL1.

In addition, the control logic circuit 170 according to one or more implementations may apply a second common source line voltage VCSL2, greater than the first common source line voltage VCSL1, to the common source line CSL during a core operation on the third cell layer CL3 (or the third string ST3).

Thus, the control logic circuit 170 may reduce a voltage difference between the plurality of third memory cells MC31 to MC34 and the common source line CSL during the core operation on the third cell layer CL3 (or the third string ST3) to reduce the second leakage current IL2.

Referring to the above-described configurations, the control logic circuit 170 may apply a relatively large second common source line voltage VCSL2 during the core operation on the third cell layer CL3 (or the third string ST3) having a relatively large leakage current (for example, the second leakage current IL2).

With the above-described configurations, the control logic circuit 170 according to one or more implementations may compensate for differences in characteristics (for example, the amount of leakage current) between the first cell layer CL1 and the third cell layer CL3.

As a result, the memory device 100 according to one or more implementations may improve the reliability of core operations.

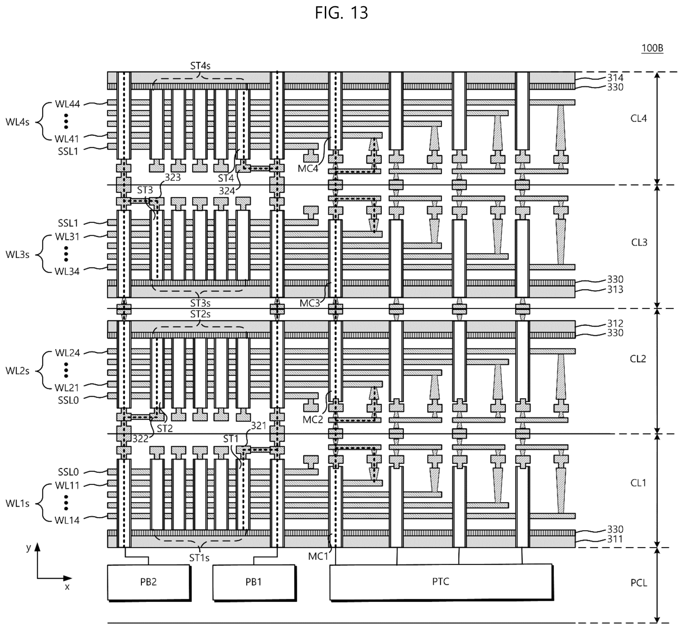

FIG. 13 is a cross-sectional view of a memory device according to one or more implementations.

Referring to FIG. 13, a memory device 100B according to one or more implementations may include a peripheral circuit layer PCL and a first cell layer CL1 to a fourth cell layer CL4 stacked on top of each other.

According one or more other implementations, the third cell layer CL3 and the fourth cell layer CL4 may be omitted. For example, the peripheral circuit layer PCL may be connected to the first cell layer CL1 and the second cell layer CL2 bonded to each other.

The memory device 100B illustrated in FIG. 13 may be understood as an example of the memory device 100 illustrated in FIG. 1. In addition, the memory device 100B illustrated in FIG. 13 may have substantially the same configuration as at least a portion of the configurations of the memory device 100A illustrated in FIG. 3.

Therefore, the same or substantially the same components are represented by the same reference numerals, and redundant descriptions will be omitted to avoid repetition.

The memory device 100B may include a first cell layer CL1 stacked on a peripheral circuit layer PCL.

The first cell layer CL1 may include a plurality of first wordlines WL1s and a plurality of first strings ST1s extending in a substantially perpendicular first direction (for example, Y-direction).

According to one or more implementations, the first string ST1 of first strings ST1s may be connected to a first page buffer PB1 through a first metal wiring 321. Accordingly, the first metal wiring 321 may be referred to a first bitline BL1 connected to the first string ST1.

In addition, the memory device 100B includes a second cell layer CL2 stacked on the first cell layer CL1.

The second cell layer CL2 may include a plurality of second wordlines WL2s and a plurality of second strings ST2s extending in a substantially perpendicular first direction (for example, Y-direction).

According to one or more implementations, among the second strings ST2s, a second string ST2 may be connected to a second page buffer PB2 through a second metal wiring 322. Accordingly, the second metal wiring 322 may be referred to as a second bitline connected to the second string ST2.

In addition, the memory device 100B includes a third cell layer CL3 stacked on the second cell layer CL2.

The third cell layer CL3 may include a plurality of third wordlines WL3s and a plurality of third strings ST3s extending in the substantially perpendicular first direction (for example, Y-direction).

According to one or more implementations, among the plurality of third strings ST3s, a third string ST3 may be connected to the second page buffer PB2 through the third metal wiring 323. Accordingly, the third metal wiring 323 may be referred to as a third bitline connected to the third string ST3.

In addition, at least a portion of the common source lines 330 included in each of the first cell layer CL1 and the fourth cell layer CL4 may be implemented as a single wiring. For example, the common source lines 330 included in each of the second cell layer CL2 and the third cell layer CL3 may be implemented as a single wiring.

In addition, the memory device 100B includes a fourth cell layer CL4 stacked on the third cell layer CL3.

The fourth cell layer CL4 may include a plurality of fourth wordlines WL4s and a plurality of fourth strings ST4s extending in the substantially perpendicular first direction (for example, Y-direction).

According to one or more implementations, among the plurality of fourth strings ST4s, a fourth string ST4 may be connected to the first page buffer PB1 through the fourth metal wiring 324. Accordingly, the fourth metal wiring 324 may be referred to as a fourth bitline connected to the fourth string ST4.

The first page buffer PB1 according to one or more implementations may be connected to the first string ST1 and the fourth string ST4.

For example, the first page buffer PB1 may be connected to the first string ST1 of the first cell layer CL1 through the first metal wiring 321 (or the first bitline BL1). In addition, the first page buffer PB1 may be connected to the fourth string ST4 of the fourth cell layer CL4 through the fourth metal wiring 324 (or the fourth bitline).

In addition, the second page buffer PB2 may be connected to the second string ST2 and the third string ST3.

For example, the second page buffer PB2 may be connected to the second string ST2 of the second cell layer CL2 through the second metal wiring 322 (or the second bitline). In addition, the second page buffer PB2 may be connected to the third string ST3 of the third cell layer CL3 through the third metal wiring 323 (or the third bitline).

According to one or more implementations, the control logic circuit 170 may control the first page buffer PB1 to perform a core operation on the first cell layer CL1 and/or the fourth cell layer CL4.

For example, the control logic circuit 170 may control the first page buffer PB1 to apply a voltage to the first string ST1 through the first bitline BL1 (or the first metal wiring 321) during a core operation on the first cell layer CL1.

In addition, the control logic circuit 170 may control the first page buffer PB1 to apply a voltage to the fourth string ST4 through the fourth metal wiring 324 (or the fourth bitline) during a core operation on the fourth cell layer CL4.

According to one or more implementations, the control logic circuit 170 may control the second page buffer PB2 to perform a core operation on the second cell layer CL2 and/or the third cell layer CL3.

For example, the control logic circuit 170 may control the second page buffer PB2 to apply a voltage to the second string ST2 through the second metal wiring 322 (or the second bitline) during a core operation on the second cell layer CL2.

In addition, the control logic circuit 170 may control the second page buffer PB2 to apply a voltage to the third string ST3 through the third metal wiring 323 (or the third bitline) during a core operation on the third cell layer CL3.

According to one or more implementations, the control logic circuit 170 may perform core operations on the first cell layer CL1 and the second cell layer CL2 using the first page buffer PB1 and the second page buffer PB2.

For example, the control logic circuit 170 may control the first page buffer PB1 to apply a voltage to the first string ST1 to perform a core operation on the first cell layer CL1.

In addition, the control logic circuit 170 may control the second page buffer PB2 to apply a voltage to the second string ST2 to perform a core operation on the second cell layer CL2.

For example, when a core operation on a structure including the first cell layer CL1 and the second cell layer CL2 is requested, the control logic circuit 170 may perform the core operations using the first page buffer PB1 and the second page buffer PB2.

In addition, when a core operation on a structure including the third cell layer CL3 and the fourth cell layer CL4 is requested, the control logic circuit 170 according to one or more implementations may perform the core operation using the first page buffer PB1 and the second page buffer PB2.

Each of the first page buffer PB1 and the second page buffer PB2 may be connected to a specified number of memory cells (for example, 8KB) in each cell layer.

For example, the first page buffer PB1 may be connected to memory cells corresponding to the specified page size in the first cell layer CL1. In addition, the second page buffer PB2 may be connected to memory cells corresponding to the specified page size in the second cell layer CL2.

As a result, the memory device 100B according to one or more implementations may increase a page size controlled by the core operation on the two cell layers CL1 and CL2 stacked adjacent to the peripheral circuit layer PCL.

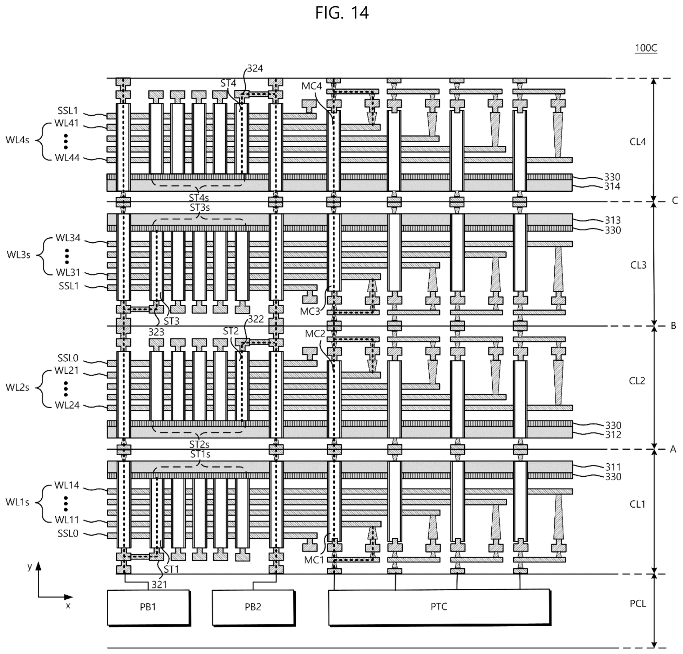

FIG. 14 is a cross-sectional view of a memory device including a plurality of stacked cell layers, according to one or more implementations.

Referring to FIG. 14, a memory device 100C according to one or more implementations may include a peripheral circuit layer PCL and a first cell layer CL1 to a fourth cell layer CL4 stacked on top of each other.

The memory device 100C illustrated in FIG. 14 may be understood as an example of the memory device 100 illustrated in FIG. 1. In addition, the memory device 100C illustrated in FIG. 14 may have substantially the same configuration as at least a portion of the configurations of the memory device 100A illustrated in FIG. 3.

Therefore, the same or substantially the same components are represented by the same reference numerals, and redundant descriptions will be omitted to avoid repetition.

The memory device 100C may include a first cell layer CL1 stacked on a peripheral circuit layer PCL.

The first cell layer CL1 may include a plurality of first wordlines WL1s and first string select lines SSLO stacked in a first direction (for example, Y-direction).

For example, the first cell layer CL1 may include a first string select line SSL0, a (1-1)-th wordline WL11 (also referred to as a first wordline of a first group of wordlines), a (1-2)-th wordline WL12 (also referred to as a second wordline of a first group of wordlines), a (1-3)-th wordline WL13 (also referred to as a third wordline of a first group of wordlines), and a (1-4)-th wordline WL14 (also referred to as a fourth wordline of a first group of wordlines), arranged in the order adjacent to the peripheral circuit layer PCL.

For example, the first string select line SSLO may be disposed to be relatively more adjacent to the peripheral circuit layer PCL compared to the (1-1)-th wordline WL11. In addition, the (1-1)-th wordline WL11 may be disposed to be more adjacent to the peripheral circuit layer PCL compared to the (1-4)-th wordline WL14.

For example, the (1-1)-th wordline WL11 may have a relatively smaller length compared to the (1-4)-th wordline WL14 and extend in a second direction (for example, X-direction).

The first cell layer CL1 may include a first string ST1 extending from a first substrate 311 (or a common source line 330) in a reverse direction of the first direction (for example, Y-direction).

A first string ST1 may be connected to a first page buffer PB1 through a first metal wiring 321. Accordingly, the first metal wiring 321 may be referred to as a first bitline BL1 connected to the first string ST1.

In addition, the memory device 100C includes a second cell layer CL2 stacked on the first cell layer CL1.

According to one or more implementations, the second cell layer CL2 may have substantially the same shape as an inverted shape of the first cell layer CL1 with respect to a virtual line A extending in a second direction (for example, X-direction).

The second cell layer CL2 may include a plurality of second wordlines WL2s and first string select lines SSLO stacked in the first direction (for example, Y-direction).

For example, the second cell layer CL2 may include a first cell layer CL1, a (2-4)-th wordline WL24, a (2-3)-th wordline WL23, a (2-2)-th wordline WL22, a (2-1)-th wordline WL21, and a first string select line SSL0, arranged in the order adjacent to the first cell array CL1.

For example, the (2-1)-th wordline WL21 may be disposed to be relatively closer to the first cell layer CL1, compared to the first string select line SSLO. In addition, the (2-4)-th wordline WL24 may be disposed to be closer to the first cell layer CL1, compared to the (2-1)-th wordline WL21.

In addition, for example, the (2-1)-th wordline WL21 may have a relatively smaller length compared to the (2-4)-th wordline WL24 and extend in the second direction (for example, X-direction).

The second cell layer CL2 may include a second string ST2 extending in the first direction (for example, Y-direction) from the second substrate 312 (or the common source line 330).

The second string ST2 may be connected to the second page buffer PB2 through the second metal wiring 322. Accordingly, the second metal wiring 322 may be referred to as a second bitline connected to the second string ST2.

In addition, the memory device 100C includes a third cell layer CL3 stacked on the second cell layer CL2.

According to one or more implementations, the third cell layer CL3 may have substantially the same shape as an inverted shape of the second cell layer CL2 with respect to a virtual line B extending in the second direction (for example, X-direction).

The third cell layer CL3 may include a plurality of third wordlines WL3s and second string select lines SSL1 stacked in the first direction (for example, Y-direction).

For example, the third cell layer CL3 may include a second string select line SSL1, a (3-1)-th wordline WL31 (also referred to as a first wordline of a third group of wordlines), a (3-2)-th wordline WL32 (also referred to as a second wordline of a third group of wordlines), a (3-3)-th wordline WL33 (also referred to as a third wordline of a third group of wordlines), and a (3-4)-th wordline WL34 (also referred to as a fourth wordline of a third group of wordlines), arranged in the order adjacent to the second cell layer CL2.

For example, the second string select line SSL1 may be disposed to be relatively closer to the second cell layer CL2 compared to a (3-1)-th wordline WL31. In addition, the (3-1)-th wordline WL31 may be disposed to be closer to the second cell layer CL2 compared to a (3-4)-th wordline WL34.

For example, the (3-1)-th wordline WL31 may have a relatively smaller length compared to the (3-4)-th wordline WL34 and extend in the second direction (for example, X-direction).

The third cell layer CL3 may include a third string ST3 extending from the third substrate 313 (or the common source line 330) in a reverse direction of the first direction (for example, Y-direction).

The third string ST3 may be connected to the first page buffer PB1 through a third metal wiring 323. Accordingly, the third metal wiring 323 may be referred to as a third bitline connected to the third string ST3.

In addition, the memory device 100C includes a fourth cell layer CL4 stacked on the third cell layer CL3.

According to one or more implementations, the fourth cell layer CL4 may have substantially the same shape as an inverted shape of the third cell layer CL3 with respect to a virtual line C extending in the second direction (for example, X-direction).

The fourth cell layer CL4 may include a plurality of fourth wordlines WL4s and a second string select line SSL1 stacked in the first direction (for example, Y-direction).

For example, the fourth cell layer CL4 may include a (4-4)-th wordline WL44 (also referred to as a fourth wordline of a fourth group of wordlines), a (4-3)-th wordline WL43 (also referred to as a third wordline of a fourth group of wordlines), a (4-2)-th wordline WL42 (also referred to as a second wordline of a fourth group of wordlines), a (4-1)-th wordline WL41 (also referred to as a first wordline of a fourth group of wordlines), and a second string select line SSL1, arranged in the order adjacent to the third cell layer CL3.

For example, the (4-1)-th wordline (WL41) may be disposed to be relatively closer to the third cell layer CL3 compared to the second string select line SSL1. In addition, the (4-4)-th wordline WL44 may be disposed to be closer to the third cell layer CL3 compared to the (4-1)-th wordline WL41.

In addition, for example, the (4-1)-th wordline WL41 may have a relatively smaller length compared to the (4-4)-th wordline WL44 and extend in the second direction (for example, X-direction).

The fourth cell layer CL4 may include a fourth string ST4 extending in the first direction (for example, Y-direction) from a fourth substrate 314 (or a common source line 330).

The fourth string ST4 may be connected to the second page buffer PB2 through
the fourth metal wiring 324. Accordingly, the fourth metallic wire 324 may be referred to as a fourth bitline connected to the fourth string ST4.

The first page buffer PB1 according to one or more implementations may be connected to the first string ST1 and the third string ST3.

For example, the first page buffer PB1 may be connected to the first string ST1 of the first cell layer CL1 through the first metal wiring 321 (or the first bitline BL1). In addition, the first page buffer PB1 may be connected to the third string ST3 of the third cell layer CL3 through the third metal wiring 323 (or the third bitline).

In addition, the second page buffer PB2 may be connected to the second string ST2 and the fourth string ST4.

For example, the second page buffer PB2 may be connected to the second string ST2 of the second cell layer CL2 through the second metal wiring 322 (or the second bitline). In addition, the second page buffer PB2 may be connected to the fourth string ST4 of the fourth cell layer CL4 through the fourth metal wiring 324 (or the fourth bitline).

According to one or more implementations, the control logic circuit 170 is configured to control the first page buffer PB1 to perform a core operation on the first cell layer CL1 and/or the third cell layer CL3.

For example, the control logic circuit 170 may control the first page buffer PB1 to apply a voltage to the first string ST1 through the first bitline BL1 (or the first metal wiring 321) during a core operation on the first cell layer CL1.

In addition, the control logic circuit 170 may control the first page buffer PB1 to apply a voltage to the third string ST3 through the third metal wiring 323 (or the third bitline) during a core operation on the third cell layer CL3.

According to one or more implementations, the control logic circuit 170 is configured to control the second page buffer PB2 to perform a core operation on the second cell layer CL2 and/or the fourth cell layer CL4.

For example, the control logic circuit 170 may control the second page buffer PB2 to apply a voltage to the second string ST2 through the second metal wiring 322 (or the second bitline) during a core operation on the second cell layer CL2.

In addition, the control logic circuit 170 may control the second page buffer PB2 to apply a voltage to the fourth string ST4 through the fourth metal wiring 324 (or the fourth bitline) during a core operation on the fourth cell layer CL4.

According to one or more implementations, the control logic circuit 170 is configured to perform core operations on the first cell layer CL1 and the second cell layer CL2 using the first page buffer PB1 and the second page buffer PB2.

For example, the control logic circuit 170 may control the first page buffer PB1 to apply a voltage to the first string ST1 to perform a core operation on the first cell layer CL1.

In addition, the control logic circuit 170 may control the second page buffer PB2 to apply a voltage to the second string ST2 to perform a core operation on the second cell layer CL2.

For example, when a core operation on a structure including the first cell layer CL1 and the second cell layer CL2 is requested, the control logic circuit 170 may perform the core operation using the first page buffer PB1 and the second page buffer PB2.

In addition, when a core operation on a structure including the third cell layer CL3 and the fourth cell layer CL4 is requested, the control logic circuit 170 according to one or more other implementations may perform the core operation using the first page buffer PB1 and the second page buffer PB2.

Each of the first page buffer PB1 and the second page buffer PB2 may be connected to memory cells corresponding to a specified page size (for example, 8KB) (or number of memory cells) in each cell layer.

For example, the first page buffer PB1 may be connected to memory cells corresponding to the specified page size in the first cell layer CL1. In addition, the second page buffer PB2 may be connected to memory cells corresponding to the specified page size in the second cell layer CL2.

As a result, the memory device 100C according to one or more implementations may increase a page size controlled in core operations on the two cell layers CL1 and CL2 stacked adjacent to the peripheral circuit layer PCL.

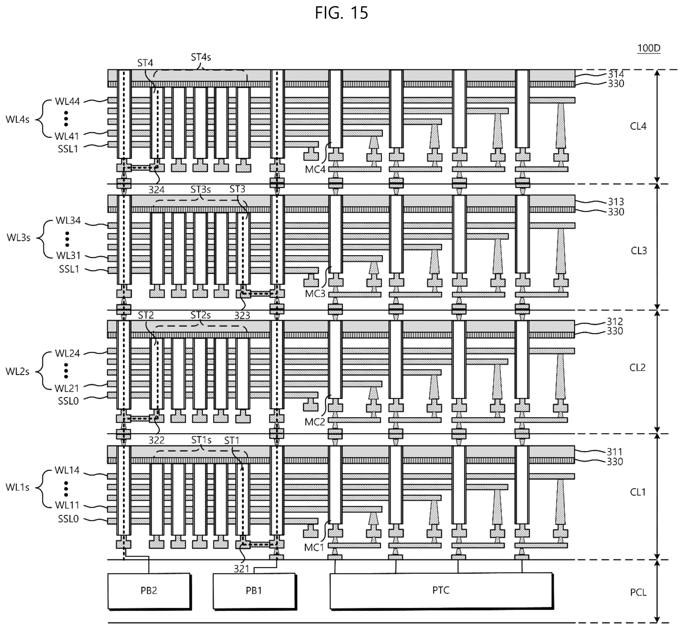

FIG. 15 is a cross-sectional view of a memory device including a plurality of stacked cell layers, according to one or more implementations.

Referring to FIG. 15, a memory device 100D according to one or more implementations may include a peripheral circuit layer PCL and a first cell layer CL1 to a fourth cell layer CL4 stacked on top of each other.

The memory device 100D illustrated in FIG. 15 may be understood as an example of the memory device 100 illustrated in FIG. 1. In addition, the memory device 100D illustrated in FIG. 15 may have substantially the same configuration as at least a portion of the configurations of the memory device 100A illustrated in FIG. 3.

Therefore, the same or substantially the same components are represented by the same reference numerals, and redundant descriptions will be omitted to avoid repetition.

The memory device 100D may include a first cell layer CL1 stacked on the peripheral circuit layer PCL.

The first cell layer CL1 may include a plurality of first wordlines WL1s and first string select lines SSLO stacked in a first direction (for example, Y-direction).

For example, the first cell layer CL1 may include a first string select line SSL0, a (1-1)-th wordline WL11, a (1-2)-th wordline WL12, a (1-3)-th wordline WL13, a (1-4)-th wordline WL14, arranged in the order adjacent to the peripheral circuit layer PCL.

For example, the first string select line SSLO may be disposed to be relatively closer to the peripheral circuit layer PCL compared to the (1-1)-th wordline WL11. In addition, the (1-1)-th wordline (WL11) may be disposed closer to the peripheral circuit layer (PCL) compared to the (1-4)-th wordline WL14.

The first cell layer CL1 may include a first string ST1 extending in a reverse direction of the first direction (for example, Y-direction) from the first substrate 311 (or the common source line 330).

The first string ST1 may be connected to the first page buffer PB1 through a first metal wiring 321. Accordingly, the first metal wiring 321 may be referred to as a first bitline BL1 connected to the first string ST1.

In addition, the memory device 100D includes a second cell layer CL2 stacked on the first cell layer CL1.

According to one or more implementations, the second cell layer CL2 may have substantially the same shape as the first cell layer CL1.

The second cell layer CL2 may include a plurality of second wordlines WL2s and first string select lines SSLO stacked in the first direction (for example, Y-direction).

For example, the second cell layer CL2 may include a first string select line SSL0, a (2-1)-th wordline WL21 (also referred to as a first wordline of a second group of wordlines), a (2-2)-th wordline WL22 (also referred to as a second wordline of a second group of wordlines), a (2-3)-th wordline WL23 (also referred to as a third wordline of a second group of wordlines), and a (2-4)-th wordline WL24 (also referred to as a fourth wordline of a second group of wordlines), arranged in the order adjacent to the first cell layer CL1.

For example, the first string select line SSLO may be disposed closer to the first cell layer CL1 compared to the (2-1)-th wordline (WL21). In addition, the (2-1)-th wordline WL21 may be disposed closer to the first cell layer CL1 compared to the (2-4)-th wordline WL24.

The second cell layer CL2 may include a second string ST2 extending in a reverse direction of the first direction (for example, Y-direction) from the second substrate 312 (or the common source line 330).

The second string ST2 may be connected to the second page buffer PB2 through a second metal wiring 322. Accordingly, the second metal wiring 322 may be referred to as a second bitline BL2 connected to the second string ST2.

In addition, the memory device 100D includes a third cell layer CL3 stacked on the second cell layer CL2.

According to one or more implementations, the third cell layer CL3 may have substantially the same shape as the second cell layer CL2.

The third cell layer CL3 may include a plurality of third wordlines WL3s and second string select lines SSL1 stacked in the first direction (for example, Y-direction).

For example, the third cell layer CL3 may include a second string select line SSL1, a (3-1)-th wordline WL31, a (3-2)-th wordline WL32, a (3-3)-th wordline WL33, and a (3-4)-th wordline WL34, arranged in order adjacent to the second cell layer CL2.

For example, the second string select line SSL1 may be disposed closer to the second cell layer CL2 compared to the (3-1)-th wordline WL31. In addition, the (3-1)-th wordline WL31 may be disposed closer to the second cell layer CL2 compared to the (3-4)-th wordline WL34.

The third cell layer CL3 may include a third string ST3 extending in a reverse direction of the first direction (for example., Y-direction) from the third substrate 313 (or the common source line 330).

The third string ST3 may be connected to the first page buffer PB1 through a third metal wiring 323. Accordingly, the third metal wiring 323 may be referred to as a third bitline BL3 connected to the third string ST3.

In addition, the memory device 100D includes a fourth cell layer CL4 stacked on the third cell layer CL3.

According to one or more implementations, the fourth cell layer CL4 may have substantially the same structure as the third cell layer CL3.

The fourth cell layer CL4 may include a plurality of fourth wordlines WL4s and the second string selection line SSL1 stacked in the first direction (for example., Y-direction).

For example, the fourth cell layer CL4 may include a second string select line SSL1, a (4-1)-th wordline WL41, a (4-2)-th wordline WL42, a (4-3)-th wordline WL43, and a (4-4)-th wordline WL44, arranged in order adjacent to the third cell layer CL3.

For example, the second string select line SSL1 may be disposed closer to the third cell layer CL3 compared to the (4-1)-th wordline WL41. In addition, the (4-1)-th wordline WL41 may be disposed closer to the third cell layer CL3 compared to the (4-4)-th wordline WL44.

The fourth cell layer CL4 may include a fourth string ST4 extending in a reverse direction of the first direction (for example, Y-direction) from a fourth substrate 314 (or the common source line 330).

The fourth string ST4 may be connected to the second page buffer PB2 through a fourth metal wiring 324. Accordingly, the fourth metal wiring 324 may be referred to as a fourth bitline BL4 connected to the fourth string ST4.

According to one or more implementations, the first page buffer PB1 may be connected to the first string ST1 and the third string ST3.

For example, the first page buffer PB1 may be connected to the first string ST1 of the first cell layer CL1 through the first metal wiring 321 (or the first bitline BL1). In addition, the first page buffer PB1 may be connected to the third string ST3 of the third cell layer CL3 through the third metal wiring 323 (or the third bitline BL3).

The second page buffer PB2 may be connected to the second string ST2 and the fourth string ST4.

For example, the second page buffer PB2 may be connected to the second string ST2 of the second cell layer CL2 through the second metal wiring 322 (or the second bitline BL2). In addition, the second page buffer PB2 may be connected to the fourth string ST4 of the fourth cell layer CL4 through the fourth metal wiring 324 (or the fourth bitline BL4).

According to one or more implementations, the control logic circuit 170 is configured to control the first page buffer PB1 to perform a core operation on the first cell layer CL1 and/or the third cell layer CL3.

For example, the control logic circuit 170 may control the first page buffer PB1 to apply a voltage to the first string ST1 through the first bitline BL1 (or the first metal wiring 321) during a core operation on the first cell layer CL1.

In addition, the control logic circuit 170 may control the first page buffer PB1 to apply a voltage to the third string ST3 through the third metal wiring 323 (or the third bitline BL3) during a core operation on the third cell layer CL3.

According to one or more implementations, the control logic circuit 170 is configured to control the second page buffer PB2 to perform a core operation on the second cell layer CL2 and/or the fourth cell layer CL4.

For example, the control logic circuit 170 may control the second page buffer PB2 to apply a voltage to the second string ST2 through the second metal wiring 322 (or the second bitline BL2) during a core operation on the second cell layer CL2.

In addition, the control logic circuit 170 may control the second page buffer PB2 to apply a voltage to the fourth string ST4 through the fourth metal wiring 324 (or the fourth bitline BL4) during a core operation on the fourth cell layer CL4.

According to one or more implementations, the control logic circuit 170 is configured to perform core operations on the first cell layer CL1 and the second cell layer CL2 using the first page buffer PB1 and the second page buffer PB2.

For example, the control logic circuit 170 may control the first page buffer PB1 to apply a voltage to the first string ST1 to perform a core operation on the first cell layer CL1.

In addition, the control logic circuit 170 may control the second page buffer PB2 to apply a voltage to the second string ST2 to perform a core operation on the second cell layer CL2.

For example, when a core operation on a structure including the first cell layer CL1 and the second cell layer CL2 is requested, the control logic circuit 170 may perform the core operation using the first page buffer PB1 and the second page buffer PB2.

Each of the first page buffer PB1 and the second page buffer PB2 may be connected to memory cells corresponding to a specified page size (for example, 8KB) (or a specified number of memory cells in each cell layer.

For example, the first page buffer PB1 may be connected to memory cells corresponding to the specified page size in the first cell layer CL1. Similarly, the second page buffer PB2 may be connected to memory cells corresponding to the specified page size in the second cell layer CL2.

As a result, the memory device 100D according to one or more implementations may increase a page size controlled during core operations on stacked cell layers CL1 and CL2.

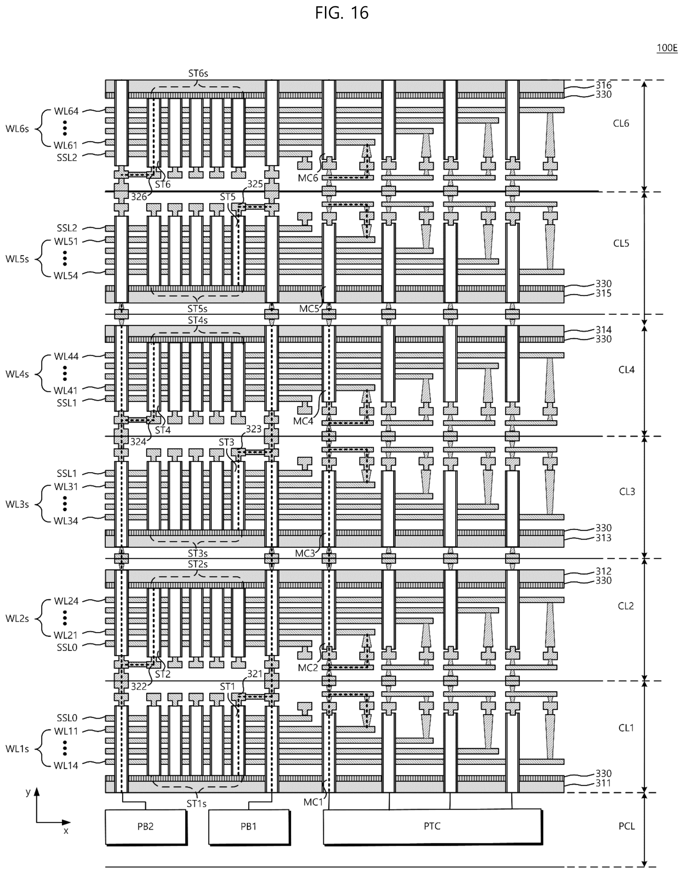

FIG. 16 is a cross-sectional view of a memory device including a first cell layer to a sixth cell layer, according to one or more implementations.

Referring to FIG. 16, a memory device 100E according to one or more implementations may include a peripheral circuit layer PCL and a first cell layer CL1 to a sixth cell layer CL6 stacked on top of each other.

The memory device 100E illustrated in FIG. 16 may be understood as an example of the memory device 100 illustrated in FIG. 1. In addition, the memory device 100E illustrated in FIG. 16 may be understood to have substantially the same configuration as the configuration of the memory device 100A illustrated in FIG. 3.

Therefore, the same or substantially the same components are represented by the same reference numerals, and redundant descriptions will be omitted to avoid repetition.

The memory device 100E may include a fifth cell layer CL5 stacked on the fourth cell layer CL4.

The fifth cell layer CL5 may have a shape extending in the second direction (for example, X-direction) and may include a plurality of fifth wordlines WL5s and third string select lines SSL2 stacked in the first direction (for example, Y-direction).

In addition, the fifth cell layer CL5 may include a plurality of fifth strings ST5s extending in the first direction (for example, Y-direction).

According to one or more implementations, the fifth string ST5 of fifth strings ST5s may be connected to the first page buffer PB1 through the fifth metal wiring 325. Accordingly, the fifth metal wiring 325 may be referred to as a fifth bitline connected to the fifth string ST5.

In addition, the memory device 100E may include a sixth cell layer CL6 stacked on the fifth cell layer CL5.

The sixth cell layer CL6 may have a shape extending in the second direction (for example, X-direction) and may include a plurality of six wordlines WL6s stacked in the first direction (for example, Y-direction) and a third string select line SSL2.

In addition, the sixth cell layer CL6 may include a plurality of sixth strings ST6s extending in the first direction (for example, Y-direction).

According to one or more implementations, among the plurality of sixth strings ST6s, a sixth string ST6 may be connected to the second page buffer PB2 through a sixth metal wiring 326. Accordingly, the sixth metal wiring 326 may be referred to as a sixth bitline connected to the sixth string ST6.

The first page buffer PB1 according to one or more implementations may be connected to a first string ST1, a third string ST3, and a fifth string ST5.

For example, the first page buffer PB1 may be connected to the first string ST1 of the first cell layer CL1 through a first metal wiring 321 (or a first bitline BL1). In addition, the first page buffer PB1 may be connected to the third string ST3 of the third cell layer CL3 through a third metal wiring 323 (or a third bitline). In addition, the first page buffer PB1 may be connected to the fifth string ST5 of the fifth cell layer CL5 through a fifth metal wiring 325 (or a fifth bitline).

In addition, the second page buffer PB2 may be connected to a second string ST2, a fourth string ST4, and a sixth string ST6.

For example, the second page buffer PB2 may be connected to the second string ST2 of the second cell layer CL2 through a second metal wiring 322 (or a second bitline). In addition, the second page buffer PB2 may be connected to the fourth string ST4 of the fourth cell layer CL4 through a fourth metal wiring 324 (or a fourth bitline). In addition, the second page buffer PB2 may be connected to the sixth string ST6 of the sixth cell layer CL6 through a sixth metal wiring 326 (or a sixth bitline).

According to one or more implementations, the control logic circuit 170 may control the first page buffer PB1 to perform core operations on the first cell layer CL1, the third cell layer CL3, and the fifth cell layer CL5.

For example, the control logic circuit 170 may control the first page buffer PB1 to apply a voltage to the first string ST1 through the first bitline BL1 (or the first metal wiring 321) during a core operation on the first cell layer CL1.

In addition, the control logic circuit 170 may control the first page buffer PB1 to apply a voltage to the third string ST3 through the third metal wiring 323 (or the third bitline upon core operation on the third cell layer CL3.

In addition, the control logic circuit 170 may control the first page buffer PB1 to apply a voltage to the fifth string ST5 through the fifth metal wiring 325 (or the fifth bitline) during a core operation on the fifth cell layer CL5.

According to one or more implementations, the control logic circuit 170 may control the second page buffer PB2 to perform core operations on the second cell layer CL2, the fourth cell layer CL4, and the sixth cell layer CL6.

For example, the control logic circuit 170 may control the second page buffer PB2 to apply a voltage to the second string ST2 through the second metal wiring 322 (or the second bitline) during a core operation on the second cell layer CL2.

In addition, the control logic circuit 170 may control the second page buffer PB2 to apply a voltage to the fourth string ST4 through the fourth metal wiring 324 (or the fourth bitline) during a core operation on the fourth cell layer CL4.

In addition, the control logic circuit 170 may control the second page buffer PB2 to apply a voltage to the sixth string ST6 through the sixth metal wiring 326 (or the sixth bitline) during a core operation on the sixth cell layer CL6.

According to one or more implementations, the control logic circuit 170 may perform core operations on the first cell layer CL1 and the second cell layer CL2 using the first page buffer PB1 and the second page buffer PB2.

For example, the control logic circuit 170 may control the first page buffer PB1 to apply a voltage to the first string ST1 to perform a core operation on the first cell layer CL1. In addition, the control logic circuit 170 may control the second page buffer PB2 to voltage to the second string ST2 to perform core operations on the second cell layer CL2.

For example, when a core operation on a structure including the first cell layer CL1 and the second cell layer CL2 is requested, the control logic circuit 170 may perform the core operation using the first page buffer PB1 and the second page buffer PB2.

In addition, when a core operation on a structure including the third cell layer CL3 and the fourth cell layer CL4 is requested, the control logic circuit 170 according to one or more implementations may perform the core operation using the first page buffer PB1 and the second page buffer PB2.

In addition, when a core operation on a structure including the fifth cell layer CL5 and the sixth cell layer CL6 is requested, the control logic circuit 170 according to one or more implementations may perform the core operations using the first page buffer PB1 and the second page buffer PB2.

Each of the first page buffer PB1 and the second page buffer PB2 may be connected to a specified page size (for example, 8KB) (or a corresponding number of memory cells) in each cell layers.

For example, the first page buffer PB1 may be connected to memory cells corresponding to the specified page size in the first cell layer CL1. Similarly, the second page buffer PB2 may be connected to memory cells corresponding to the specified page size in the second cell layer CL2.

As a result, the memory device 100E according to one or more implementations may increase a page size controlled during core operations on the two stacked cell layers CL1 and CL2.

As described above, the control logic circuit 170 according to one or more implementations may perform core operations on the two cell layers CL1 and CL2 stacked adjacent to the peripheral circuit layer PCL using different page buffers PB1 and PB2.

Thus, the memory device 100 according to one or more implementations may increase the page size controlled during core operations on adjacent cell layers CL1 and CL2, among the plurality of stacked cell layers CL1 to CL4.

In addition, according to one or more implementations, wordlines corresponding to each other in the first to fourth cell layers CL1 to CL4 may be simultaneously driven by the same pass transistor.

Thus, the memory device 100 (or the pass transistor circuit PTC) according to one or more implementations may be implemented in a relatively smaller area compared to a case of separately driving wordlines of the first to fourth cell layers CL1 to CL4.

In addition, when characteristics of the stacked cell layers differ, the control logic circuit 170 according to one or more implementations may control the magnitude and/or timing of voltages applied to respective cell layers to be different.

For example, when characteristics of cell layers connected to different page buffers PB1 and PB2 are different, the control logic circuit 170 may control the magnitude of voltages (for example, a forcing voltage VFBL), applied through a bitline of each cell layer, to be different.

For example, when characteristics of stacked cell layers are different, the control logic circuit 170 may control the magnitude of a voltages (for example, a program voltage or a pass voltage), applied to a word line of each cell layer, to be different.

As a result, the control logic circuit 170 may compensate for a characteristic difference between a plurality of cell layers. Moreover, the memory device 100 according to one or more implementations may improve the reliability of core operations.

As set forth above, according to one or more implementations, a memory device may increase a page size of a core operation for two adjacent cell layers among a plurality of stacked cell layers.

While one or more implementations have been shown and described above, it will be apparent to those skilled in the art that modifications and variations could be made without departing from the scope of the present inventive concept as defined by the appended claims.

## Claims

1. A memory device (100) comprising:
a first cell layer (CL1) including a first string (ST1);
a second cell layer (CL2) stacked on the first cell layer (CL1), and including a second string (ST2);
a third cell layer (CL3) stacked on the second cell layer (CL2), and including a third string (ST3);
a fourth cell layer (CL4) stacked on the third cell layer (CL3), and including a fourth string (ST4);
a first page buffer (PB1) connected to the first string (ST1), and to the third string (ST3) or the fourth string (ST4), ;
a second page buffer (PB2) connected to the second string (ST2), wherein the second page buffer (PB2) is also connected to the fourth string (ST4) when the first page buffer (PB1) is connected to the third string (ST3), or the second page buffer (PB2) is connected to the third string (ST3) when the first page buffer (PB1) is connected to the third string (ST3),; and
a control logic circuit (170) configured to control the first page buffer (PB1) and the second page buffer (PB2) to perform a respective core operation on each of the first cell layer (CL1) and the second cell layer (CL2).

2. The memory device (100) of claim 1, wherein
the control logic circuit (170) is configured, during the respective core operation on each of the first cell layer (CL1) and the second cell layer (CL2), to:
perform a first core operation on the first string (ST1) through the first page buffer (PB1); and
perform a second core operation on the second string (ST2) through the second page buffer (PB2).

3. The memory device (100) of claim 1 or 2, further comprising:
a first metal contact (MC1) connected to a (1-1)-th wordline (WL11) included in the first cell layer (CL1);
a second metal contact (MC2) connected to a (2-1)-th wordline included in the second cell layer (CL2);
a third metal contact (MC3) connected to a (3-1)-th wordline included in the third cell layer (CL3);
a fourth metal contact (MC4) connected to a (4-1)-th wordline included in the fourth cell layer (CL4); and
a first pass transistor (PT11) connected to a first end of the first metal contact (MC1),
wherein the first metal contact (MC1), the second metal contact (MC2), the third metal contact (MC3), and the fourth metal contact (MC4) are electrically connected to each other.

4. The memory device (100) of claim 3, further comprising,
a first switch circuit (SW1) connected to the first pass transistor (PT11),
wherein the control logic circuit (170) is configured to control the first switch circuit (SW1) to control a voltage applied to the first pass transistor (PT11), transferred from a first row line (RL1).

5. The memory device (100) of claim 3 or 4, wherein
the first cell layer (CL1) and the second cell layer (CL2) are connected to a first string select line (SSLO), and
the third cell layer (CL3) and the fourth cell layer (CL4) are connected to a second string select line (SSL1).

6. The memory device (100) of claim 5, wherein
the control logic circuit (170) is configured, during a program operation on the first string (ST1), to:
activate the first string (ST1) through the first string select line (SSLO); and
apply a first program voltage to the (1-1)-th wordline (WL11) through the first pass transistor (PT11) and the first metal contact (MC1).

7. The memory device (100) of claim 6, wherein
during a program operation on the third string (ST3), the control logic circuit (170) is configured to, based on a program speed of memory cells (MC31 to MC34) in the third cell layer (CL3) being lower than a program speed of memory cells (MC11 to MC14) in the first cell layer (CL1),:
activate the third string (ST3) through the second string select line (SSL1); and
apply a second program voltage, greater than the first program voltage, to the (3-1)-th wordline (WL31) through the first pass transistor (PT11), the first metal contact (MC1), and the third metal contact (MC3).

8. The memory device (100) of any one of claims 3 to 7, wherein
the control logic circuit (170) is configured to:
apply a first read voltage to the (1-1)-th wordline (WL11) during a read operation on the first string (ST1), and
apply a second read voltage, greater than the first read voltage, to the (3-1)-th wordline (WL31) during a read operation on the third string (ST3).

9. The memory device (100) of any one of claims 3 to 8, wherein
the control logic circuit (170) is configured to, based on a resistance of the first string (ST1) being smaller than a resistance of the second string (ST2), and during a read operation on the first cell layer (CL1) and the second cell layer (CL2):
apply a first bitline voltage to the first string (ST1) through the first page buffer (PB1); and
apply a second bitline voltage, greater than the first bitline voltage, to the second string (ST2) through the second page buffer (PB2).

10. The memory device (100) of any one of claims 1 to 9, wherein
the control logic circuit (170) is configured to, based on an amount of current leaking from first memory cells (MC11 to MC14) included in the first string (ST1) to a common source line (CSL) being smaller than an amount of current leaking from third memory cells (MC31 to MC34) included in the third string (ST3) to the common source line (CSL):
apply a first common source line voltage through the common source line (CSL) during the core operation on the first string (ST1), and
apply a second common source line voltage, which is greater than the first common source line voltage, through the common source line (CSL) during a core operation on the third string (ST3).

11. The memory device (100) of claim 10, wherein
the control logic circuit (170) is configured to:
perform a third core operation on the third string (ST3) through the first page buffer (PB1); and
perform a fourth core operation on the fourth string (ST4) through the second page buffer (PB2).

12. The memory device (100) of any one of claims 1 to 11, further comprising:
a fifth cell layer (CL5) stacked on the fourth cell layer (CL4); and
a sixth cell layer (CL6) stacked on the fifth cell layer (CL5),
wherein
the first page buffer (PB1) is connected to a fifth string (ST5) of the fifth cell layer (CL5),
the second page buffer (PB2) is connected to a sixth string (ST6) of the sixth cell layer (CL6), and
the control logic circuit (170) is configured to control the first page buffer (PB1) and the second page buffer (PB2) to perform a respective core operation on each of the fifth cell layer (Cl5) and the sixth cell layer (CL6).

13. The memory device (100) of claim 12, wherein
the control logic circuit (170) is configured to:
perform a fifth core operation on the fifth string (ST5) through the first page buffer (PB1); and
perform a sixth core operation on the sixth string (ST6) through the second page buffer (PB2).

14. The memory device (100) of any one of claims 1 to 13, wherein
during a program operation, the control logic circuit (170) is configured to, based on a program voltage dependent change in threshold voltage of memory cells being larger in the first cell layer (CL1) than in the second cell layer (CL2):
apply a first forcing voltage to a first bitline (BL1) connected to the first string (ST1) through the first page buffer (PB1), and
apply a second forcing voltage, smaller than the first forcing voltage, to a second bitline (BL2) connected to the second string (ST2) through the second page buffer (PB2).

15. The memory device (100) of claim 14, wherein
during a program operation, the control logic circuit (170) is configured to, based on a program voltage dependent change in threshold voltage of memory cells being larger in the third cell layer (CL3) than in the fourth cell layer (CL4):
apply a third forcing voltage to a third bitline (BL3) connected to the third string (ST3) through the first page buffer (PB1), and
apply a fourth forcing voltage, smaller than the third forcing voltage, to a fourth bitline (BL4) connected to the fourth string (ST4) through the second page buffer (PB2).
